# EUROPÄISCHE PATENTSCHRIFT

(11) **EP 3 063 833 B1**
(45) Veröffentlichungstag und Bekanntmachung des Hinweises auf die Patenterteilung: **06.01.2021**
(21) Anmeldenummer: 14784489.8
(22) Anmeldetag: 17.10.2014
(51) Int. Cl.: H01R 9/24, H01R 27/02, H05K 7/14

(54) **ANSCHLUSSZEILE FÜR EINE ANSCHLUSSVORRICHTUNG UND VERFAHREN ZUR HERSTELLUNG EINER ANSCHLUSSZEILE FÜR EINE ANSCHLUSSVORRICHTUNG**
TERMINAL ROW FOR A TERMINAL DEVICE AND METHOD FOR MAKING A TERMINAL ROW FOR A TERMINAL DEVICE
LIGNE DE RACCORDEMENT POUR DISPOSITIF DE RACCORDEMENT ET MÉTHODE DE RÉALISATION D'UNE LIGNE DE RACCORDEMENT POUR DISPOSITIF DE RACCORDEMENT.

(30) Priorität: 28.10.2013 DE 102013111867
(43) Veröffentlichungstag der Anmeldung: 07.09.2016
(73) Patentinhaber: Phoenix Contact GmbH & Co. KG, 32825 Blomberg (DE)
(72) Erfinder: BEST, Frank, 31675 Bückeburg (DE); UNGER, Eduard, 33729 Bielefeld (DE); SÖFKER, Jörg, 32657 Lemgo (DE)
(74) Vertreter: Muth, Bruno
(86) Internationale Anmeldenummer: PCT/EP2014/072285
(87) Internationale Veröffentlichungsnummer: WO 2015/062877

(56) Entgegenhaltungen:
- WO-A1-2007/010270
- DE-C1- 19 630 860
- GB-A- 2 256 542
- US-A- 5 351 391
- US-A- 6 059 615
- US-A1- 2005 170 678

## Beschreibung

Die Erfindung betrifft eine Anschlusszeile für eine Anschlussvorrichtung nach dem Oberbegriff des Anspruchs 1 und ein Verfahren zur Herstellung einer Anschlusszeile.

Eine derartige Anschlusszeile ist in eine Einsetzrichtung an ein Elektronikgehäuse ansetzbar und ist mit einem in dem Elektronikgehäuse aufzunehmenden Elektronikbauteil, insbesondere einer Leiterplatte, verbindbar. An die Anschlusszeile kann eine vorbestimmte Anzahl von elektrischen Einzelleitern oder Steckern zum Herstellen einer Verbindung der elektrischen Einzelleiter oder Stecker mit dem Elektronikbauteil angeschlossen werden.

Solche Anschlusszeilen werden herkömmlich an modularen Elektronikgeräten verwendet, um eine Anschlusstechnik beispielsweise für Sensoren und Aktoren an eine Steuerelektronik oder dergleichen zur Verfügung zu stellen. Solche Elektronikgeräte finden beispielsweise in Industrieanlagen, z.B. Montageanlagen, in Zusammenspiel mit so genannten Feldbussystemen Verwendung und können in modularer Weise an eine Trägerschiene angesteckt werden, um in kompakter Weise z.B. in einer Werkshalle angeordnet zu werden. An die Anschlusszeile werden beispielsweise Sensoren, von denen Sensorsignale erhalten werden, und Aktoren, an die Steuersignale ausgegeben werden, angeschlossen, wobei zusätzlich auch Anzeigeelemente zum Anzeigen von Systemzuständen oder dergleichen oder Bedienelemente zur Eingabe eines Steuerbefehls oder zur Regelung von Zustandsgrößen vorgesehen sein können.

Aufgrund der Komplexität und Unterschiedlichkeit der Anforderungen an Elektronikgeräte beispielsweise für Montageanlagen werden heutzutage solche Elektronikgeräte dediziert für eine bestimmte Verwendung entwickelt und hergestellt. Ein bestimmtes Elektronikgerät enthält hierbei in einem modularen Elektronikgehäuse ein anhand der bestehenden Anforderungen konzipiertes Elektronikbauteil in Form einer Leiterplatte, an die eine in bestimmter Weise konzipierte Anschlusszeile zum Anschließen von elektrischen Einzelleitern oder Steckern an das Elektronikbauteil angebracht wird. Weil die Anforderungen an die Anschlusszeile hierbei von dem Elektronikbauteil bestimmt sind, müssen für unterschiedliche Elektronikbauteile ganz unterschiedliche Anschlusszeilen verwendet werden. Dies macht die Herstellung solcher Anschlusszeilen komplex und vielfältig und erhöht somit deren Kosten.

Herkömmlich ist bereits vorgesehen worden, an einer Anschlusszeile unterschiedliche Anschlussbauelemente, beispielsweise Stecker oder Anschlussklemmen, vorzusehen, die an eine Blende oder dergleichen angesetzt sind, um die Anschlusszeile auszubilden. Dies erleichtert die Herstellung von solchen Anschlusszeilen zwar etwas, erfordert aber dennoch eine Herstellung von spezifischen Bauelementen, beispielsweise dedizierten Blenden, zur Fertigung einer bestimmten Anschlusszeile.

Aus der DE 10 2011 055 920 B3 ist eine Steuerungsvorrichtung zum automatisierten Steuern einer technischen Anlage bekannt, bei der an ein erstes Modulteil ein zweites Modulteil angesetzt ist. Das erste Modulteil nimmt hierbei eine Leiterplatte auf, während an das zweite Modulteil beispielsweise Anschlüsse in Form von Federzugklemmen angesetzt sein können.

Aus der DE 38 84 329 T2 ist eine Verbindungsklemme bekannt, die einen Anschluss mehrerer elektrischer Kabel unterschiedlichen Querschnitts erlaubt.

Aus der DE 10 2008 027 399 A1 ist eine Anschlussvorrichtung bekannt, bei der mehrere einpolige Anschlussklemmensegmente aneinander angereiht und miteinander verklebt sind.

Aus WO 2007/010270 A1 ist allgemeiner Baukasten zur Bildung eines modulares Energieversorgung- und Verteilungssystem bekannt, bei dem gleichartige kastenförmige Module aneinander gesetzte werden.

Aus DE 196 30 860 C1 ist eine Reihenklemme der bekannt, an der in gleichgeformte Anschlusskörper für die Energie-/Signalerteilung angeordnet sind.

Aus der US 2005/170678 A1 ist ein Gehäusekörper bekannt, der bestückt wird mit Modulen, die wiederum über einer Leiterplatte mittels einer linearen Führung in den Gehäusekörper eingeführt werden, wobei eine Blende vorgesehen ist, die eine für den Gehäusekörper vorgesehene Wandöffnung bedeckt.

Aus der US 6 059 615 A sind elektrische Anschlusseinrichtungen für eine Leiterplatte bekannt, bei denen zur Bildung eines zeilenförmigen Leiterplattenanschlusses unterschiedliche Module verschiedener Größe aneinander angesetzt werden können. Dabei ist an die Anschlusseinrichtung eine vorbestimmte Anzahl von elektrischen Einzelleitern oder Steckern zum Herstellen einer Verbindung von elektrischen Einzelleitern mit der Leiterplatte anschließbar.

Aus der GB 2 256 542 A werden elektrische Elemente mittels eines Halterahmens in einer Anordnung gehalten werden, bei der die Elemente zwar jeweils an dem Rahmen, aber nicht aneinander gehalten werden.

Aufgabe der vorliegenden Erfindung ist es, eine Anschlusszeile und ein Verfahren zur Herstellung einer Anschlusszeile zur Verfügung zu stellen, die eine einfache Herstellung zur Verwendung an einem Elektronikgerät in Verbindung mit einem Elektronikbauteil ermöglichen, ohne dass für das Elektronikgerät mit dem darin angeordneten Elektronikbauteil eine vollständige Neukonzeption der Anschlusszeile vorgenommen werden muss.

Diese Aufgabe wird durch einen Gegenstand mit den Merkmalen des Anspruchs 1 gelöst.

Demnach ist die mindestens eine Anschlusszeile zusammengesetzt aus einer Mehrzahl von Grundgehäusen, von denen sich zumindest zwei Grundgehäuse unterscheiden, wobei die Grundgehäuse in einem Vormontagezustand getrennt voneinander vorliegen und zur Bildung der Anschlusszeile entlang einer Anreihrichtung aneinander ansetzbar sind.

Die vorliegende Erfindung geht von dem Gedanken aus, eine Anschlusszeile nach Art eines Baukastens aus einer Mehrzahl von Grundgehäusen zusammenzusetzen. Abhängig von den Anforderungen, die an eine Anschlusszeile - bedingt durch das Elektronikbauteil, mit dem die Anschlusszeile zu verbinden ist - gestellt werden, können hierbei unterschiedliche Grundgehäuse in modularer Weise aneinander angesetzt werden und bilden in einem Montagezustand die Anschlusszeile aus, die sodann mit dem Elektronikbauteil verbunden und in ein Elektronikgehäuse eingesetzt werden kann.

Dadurch, dass zur Herstellung der Anschlusszeile aus unterschiedlichen, modular vorliegenden Grundgehäusen ausgewählt werden kann, die zur Bildung der Anschlusszeile aneinander angesetzt werden, ergibt sich eine einfache, modulare Herstellung der Anschlusszeile aus bestehenden Grundelementen, was eine dedizierte Konzeption und Herstellung von Bauelementen nur für eine bestimmte Anschlusszeile überflüssig macht.

Die Grundgehäuse weisen jeweils eine in Anreihrichtung gemessene Länge auf, die einem vorbestimmten Teilungsmaß oder einem ganzzahligen Vielfachen des vorbestimmten Teilungsmaßes entspricht. In Anreihrichtung betrachtet, lässt sich die Anschlusszeile somit unterteilen in eine vorbestimmte Anzahl von Teilungseinheiten, beispielsweise neun Teilungseinheiten, wobei die Länge einer Teilungseinheit dem vorbestimmten Teilungsmaß entspricht. Jedes Grundgehäuse nimmt hierbei die Länge einer oder mehrerer Teilungseinheiten ein. Dadurch, dass die Länge jedes Grundgehäuses in Anreihrichtung anhand eines vorbestimmten Teilungsmaßes bemessen ist, wird sichergestellt, dass eine vorbestimmte Anzahl von Grundgehäusen zur Ausbildung einer Anschlusszeile mit einer vorbestimmten Gesamtlänge aneinander angesetzt werden können und dabei die Gesamtlänge der Anschlusszeile einem vorbestimmten Maß entspricht, das beispielsweise durch das Elektronikgehäuse und die Länge einer daran vorgesetzten Ansetzöffnung vorgegeben ist. Unterschiedliche Grundgehäuse können somit in einfacher Weise miteinander kombiniert werden, wobei in einfacher Weise eine gewünschte Gesamtlänge der Anschlusszeile erhalten werden kann.

Die Grundgehäuse sind vorzugsweise aus einem elektrisch isolierenden Material, beispielsweise einem Kunststoff, gefertigt. Die Grundgehäuse sind somit elektrisch isolierend, so dass an die Grundgehäuse angeschlossene elektrische Einzelleiter oder Stecker elektrisch voneinander getrennt sind. Das Grundgehäuse kann dazu einen elektrisch isolierenden Körper aufweisen, an oder in dem unter Umständen elektrisch leitende Komponenten zur Herstellung von Leiterbahnen oder von Kontakten angeordnet sein können. Dient das Grundgehäuse als reines Isolationselement und trägt es keine Kontakte, so kann es auch insgesamt isolierend ausgebildet sein, also keine elektrisch leitfähigen Komponenten aufweisen.

Die Grundgehäuse können grundsätzlich ganz unterschiedlich ausgestaltet sein. Um hierbei ein Anschließen von elektrischen Einzelleitern oder Steckern zu ermöglichen, ist in zumindest einem Grundgehäuse der Anschlusszeile mindestens eine Kontaktaufnahme zur Aufnahme eines elektrischen Kontakts angeordnet. Beispielsweise können an einem Grundgehäuse ein, zwei, vier, sechs oder acht Kontaktaufnahmen mit jeweils einem darin angeordneten elektrischen Kontakt vorgesehen sein, wobei die Kontaktaufnahmen beispielsweise nach Art von Anschlussklemmen zum Anschließen von elektrischen Einzelleitern ausgestaltet sein können. Denkbar ist aber auch, an einem Grundgehäuse beispielsweise eine Kontaktaufnahme mit mehreren darin angeordneten elektrischen Kontakten vorzusehen, wobei an die Kontaktaufnahme beispielsweise ein zugeordneter Stecker angeschlossen werden kann.

In einer konkreten Ausgestaltung sind vorzugsweise mehrere Grundgehäuse vorgesehen, die sich hinsichtlich ihrer Kontaktaufnahmen oder hinsichtlich ihrer an den Kontaktaufnahmen angeordneten Kontakte unterscheiden. Die Grundgehäuse können sich beispielsweise durch die Anzahl der Kontaktaufnahmen und/oder durch die geometrische Form oder Abmessung der Kontaktaufnahmen unterscheiden.

Beispielsweise können an einem Grundgehäuse ein, zwei, vier, sechs oder acht Kontaktaufnahmen zur Anbindung von ein, zwei, vier, sechs oder acht elektrischen Einzelleitern vorgesehen sein, während an einem anderen Grundgehäuse eine unterschiedliche Anzahl von Kontaktaufnahmen vorgesehen ist. Abhängig beispielsweise von der Querschnittsgröße eines elektrischen Einzelleiters können die Kontaktaufnahmen hierbei unterschiedliche Abmessungen aufweisen, wobei zum Anschließen eines elektrischen Einzelleiters mit einem großen Querschnitt beispielsweise eine vergleichsweise große Kontaktaufnahme vorgesehen ist. Auch die geometrische Form der Kontaktaufnahme kann unterschiedlich sein: Beispielsweise kann eine Kontaktaufnahme eine kreisrunde Öffnung oder auch eine viereckige, beispielsweise quadratische, Öffnung zum Anschließen eines elektrischen Einzelleiters ausbilden.

Ebenso können sich die Grundgehäuse durch die Anzahl von in die Kontaktaufnahmen eingesetzten Kontakten, durch einen Abstand zwischen zwei Kontakten benachbarter Kontaktaufnahmen, durch die Anordnung der Kontakte in den Kontaktaufnahmen, durch die Abmessung der Kontakte und/oder durch die geometrische Form der Kontakte unterscheiden. An unterschiedlichen Grundgehäusen können beispielsweise unterschiedlich viele Kontakte angeordnet sein, wobei die Anzahl der Kontakte nicht notwendigerweise mit der Anzahl der Kontaktaufnahmen korreliert. An unterschiedlichen Grundgehäusen können auch jeweils eine gleiche Anzahl von Kontakten, beispielsweise zwei Kontakte, angeordnet sein, wobei sich der Abstand zwischen den Kontakten zwischen den Grundgehäusen unterscheidet oder die Kontakte eine unterschiedliche Abmessung, beispielsweise einen unterschiedlichen Durchmesser oder eine unterschiedliche geometrische Form (flache Kontakte, runde Kontakte) aufweisen.

Abhängig von den Anforderungen an die Anschlusszeile können unterschiedliche Grundgehäuse miteinander kombiniert werden, um die Anschlusszeile auszubilden, wobei die Grundgehäuse in modularer Weise vorgehalten werden und ein Hersteller in einfacher Weise aus den ihm vorliegenden Grundgehäusen auswählt und diese zur Bildung der Anschlusszeile zusammensetzt.

Um ein Grundgehäuse mit dem Elektronikbauteil, beispielsweise einer Leiterplatte, zu verbinden, kann das Grundgehäuse an einer parallel zur Anreihrichtung und zur Einsetzrichtung erstreckten Querwandung mindestens einen Anschlussstift zur elektrischen Kontaktierung des Elektronikbauteils aufweisen. Sollen mehrere Grundgehäuse mit dem Elektronikbauteil elektrisch kontaktiert werden, weisen entsprechend mehrere Grundgehäuse solche Anschlussstifte auf, wobei an jedem Grundgehäuse abhängig von der erforderlichen Anzahl der Kontaktierungen ein oder mehrere Anschlussstifte vorgesehen sein können. Sind an einem Grundgehäuse beispielsweise vier Kontakte an vier Kontaktaufnahmen vorgesehen, so weist das Grundgehäuse vorzugsweise auch vier Anschlussstifte zur elektrischen Kontaktierung des Elektronikbauteils auf, so dass über das Grundgehäuse eine elektrische Verbindung von beispielsweise vier Einzelleitern mit Kontakten an dem Elektronikbauteil hergestellt werden kann. Die Anschlussstifte stehen hierbei quer zur Anreihrichtung und zur Einsetzrichtung von der Querwandung des Grundgehäuses vor, so dass das Grundgehäuse quer zur Anreihrichtung und zur Einsetzrichtung an das Elektronikbauteil angesetzt werden kann.

Ein solcher Anschlussstift kann grundsätzlich auch anders orientiert sein, beispielsweise entlang der Einsetzrichtung.

Die Grundgehäuse sind in einem Montagezustand, in dem die Grundgehäuse aneinander angesetzt sind, über die aneinander anliegenden Seitenwandungen beispielsweise formschlüssig, kraftschlüssig oder stoffschlüssig und somit fest miteinander verbunden. Für eine formschlüssige Verbindung können benachbarte Grundgehäuse beispielsweise über die aneinander anliegenden Seitenwandungen miteinander verrastet sein. Oder geeignete Formschlusselemente können in geeignete Führungen, beispielsweise nach Art einer Schwalbenschwanzführung, eingeführt sein. Für eine kraftschlüssige Verbindung können beispielsweise Stifte in zugeordnete Öffnungen eingepresst sein, so dass aufgrund des Presssitzes eine kraftschlüssige Verbindung hergestellt wird. Eine stoffschlüssige Verbindung kann beispielsweise durch Anbringen einer Schweißverbindung oder auch durch die Herstellung eines Stoffschlusses durch Säure oder dergleichen hergestellt sein.

Eine Verbindung zweier Grundgehäuse kann beispielsweise mittels Steck- oder Rastverbindungen und zusätzlich mittels Verkleben erfolgen, wie dies beispielsweise aus der DE 10 2008 027 399 A1 für Anschlussklemmensegmente zur Ausbildung einer (jedoch nicht an ein Elektronikgehäuse ansetzbaren) mehrpoligen Anschlussklemme bekannt ist.
Oder die Grundgehäuse können durch Verkleben nach Art des in der WO 2008/019833 A1 beschriebenen Verfahrens miteinander verbunden werden.

Sind die Grundgehäuse über die aneinander anliegenden Seitenwandungen in dem Montagezustand fest miteinander verbunden, ist eine modulare Anschlusszeile geschaffen, die als modulare Einheit an das zugeordnete Elektronikbauteil, beispielsweise eine Leiterplatte, angesetzt und in ein Elektronikgehäuse eingesetzt werden kann. Weisen die Grundgehäuse jeweils eine anhand eines vorbestimmten Teilungsmaßes bemessene Länge auf und werden sie jeweils zur Bildung einer Anschlusszeile einer vorbestimmten, einheitlichen Gesamtlänge zusammengesetzt, kann die Verbindung der Grundgehäuse beispielsweise unter Stoffschluss in einem einheitlichen Werkzeug hergestellt werden, in das beispielsweise eine vorbestimmte Anzahl von Grundgehäusen eingesetzt und in dem Werkzeug miteinander verbunden wird.

In einer konkreten Ausgestaltung ist an der ersten Seitenwandung eines Grundgehäuses mindestens eine Verbindungsöffnung und an der zweiten Seitenwandung mindestens ein entlang der Anreihrichtung von der zweiten Seitenwandung vorspringendes Verbindungselement angeordnet. In einem Montagezustand, in dem die Grundgehäuse aneinander angesetzt sind, greift das mindestens eine Verbindungselement eines Grundgehäuses in mindestens eine Verbindungsöffnung eines benachbarten, anderen Grundgehäuses ein und stellt somit eine formschlüssige und/oder kraftschlüssige Verbindung zwischen den Grundgehäusen her.

Die Grundgehäuse können alternativ auch an jeder Seitenwandung mindestens eine Verbindungsöffnung aufweisen, wobei die Verbindung zwischen zwei Grundgehäusen über mindestens einen gesonderten, in die Verbindungsöffnungen beider aneinander angrenzender Grundgehäuse einzusteckenden Verbindungsstift erfolgt.

Das Grundgehäuse muss nichtnotwendigerweise zum Anschließen eines elektrischen Einzelleiters oder eines Steckers ausgestaltet sein. Das Grundgehäuse kann beispielsweise auch ein Blendenelement, ein Bedienelement mit einem daran angeordneten, verstellbaren Verstellelement oder ein Anzeigeelement mit einer daran angeordneten Anzeigeeinrichtung ausbilden. Ein Blendenelement stellt eine Abdeckung nach außen hin zur Verfügung. Ein Blendenelement kann hierbei auch zur Schaffung eines größeren Isolierungsabstands zwischen zwei Kontakten verwendet werden. Ein Bedienelement kann beispielsweise einen Verstellknopf zum Verstellen eines Potentiometers oder einen Schalter oder dergleichen zur Vornahme eines Eingabebefehls aufweisen. Ein Anzeigeelement kann beispielsweise eine Leuchtdiode oder auch ein Bildschirmelement aufweisen, um einen Systemzustand anzuzeigen oder Informationen auszugeben.

Vorzugsweise weisen die Grundgehäuse jeweils dieselbe Breite, gemessen entlang einer Breitenrichtung quer zur Anreihrichtung und quer zur Einsetzrichtung, auf. Die Grundgehäuse können somit zur Schaffung einer Anschlusszeile aneinander angesetzt werden, deren Breite entlang der Anreihrichtung konstant ist.

Die Grundgehäuse sind vorzugsweise in einem Montagezustand so zueinander angeordnet, dass sie gemeinsam eine ebene Anschlussfläche ausbilden, an die die elektrischen Einzelleiter oder Stecker anschließbar sind. Die Anschlussfläche liegt in einer Ebene und bildet somit eine bündige Front nach außen hin aus, so dass ein Anschluss von Einzelleitern oder Steckern in einer Ebene erfolgen kann. Die Grundgehäuse können hierbei beispielsweise auch dieselbe Tiefe - gemessen entlang der Einsetzrichtung - aufweisen, wobei auch denkbar und möglich ist, dass unterschiedliche Grundgehäuse eine unterschiedliche Tiefe aufweisen. Weisen die Grundgehäuse dieselbe Tiefe auf, so können die Grundgehäuse mit ihren Oberseiten (die entgegen der Einsetzrichtung weisen) eine einheitliche, plane Außenfläche bereitstellen. Bei Grundgehäusen unterschiedlicher Tiefe können einzelne Grundgehäuse entlang der Einsetzrichtung mit ihren Oberseiten im Vergleich zu anderen Grundgehäusen zurückversetzt sein oder nach außen hin vorspringen.

In einer vorteilhaften Ausgestaltung weisen die Grundgehäuse jeweils gleiche Außenabmessungen auf. Die Anschlusszeile kann somit durch Grundgehäuse zusammengesetzt werden, die in ihren äußeren Abmessungen, also ihrer Breite, Tiefe und Länge jeweils gleich sind und somit, mit Bezug auf ihre Außenabmessungen, gleiche Bausteine zur Ausbildung der Anschlusszeile bereitstellen. Die Grundgehäuse unterscheiden sich hierbei aber zumindest teilweise beispielsweise durch die an den Grundgehäusen vorgesehenen Kontaktaufnahmen oder durch die Anzahl der Kontakte oder auch dadurch, dass ein Grundgehäuse ein Blendenelement, ein Bedienelement oder ein Anzeigeelement und ein anderes Grundgehäuse ein Anschlusselement zum Anschließen von elektrischen Einzelleitern oder einem Stecker bereitstellt.

In einer konkreten Ausgestaltung können die Grundgehäuse jeweils einteilig ausgebildet sein. Jedes Grundgehäuse stellt somit einen einheitlichen Gehäusebaustein zur Verfügung.

In einer anderen Ausgestaltung kann das Grundgehäuse auch zweiteilig ausgebildet sein. So kann das Grundgehäuse ein Grundleistenmodul und ein an das Grundleistenmodul ansetzbares Steckermodul aufweisen. Das Grundleistenmodul ist hierbei mit dem Elektronikbauteil zu verbinden, während an das Steckermodul elektrische Einzelleiter oder ein Stecker angeschlossen werden können.

Das Steckermodul kann in die Einsetzrichtung an das Grundleistenmodul angesetzt werden und ist in angesetztem Zustand mechanisch fest an dem Grundleistenmodul gehalten.

Hierzu können an dem Steckermodul beispielsweise an einer dem Grundleistenmodul zugewandten Unterseite ein oder mehrere Kontaktzapfen angeordnet sein, die in dem eingesteckten Zustand in eine oder mehrere zugeordnete Kontaktaufnahmen des Grundleistenmoduls eingreifen.

Grundsätzlich ist hierbei auch vorstellbar, dass an ein Grundleistenmodul mehrere Steckermodule oder umgekehrt an mehrere nebeneinander angeordnete Grundleistenmodule ein Steckermodul angeschlossen werden können.

Bei Ausgestaltung des Grundgehäuses in zweiteiliger Form aus einem Grundleistenmodul und einem Steckermodul sind vorzugsweise die Grundleistenmodule benachbarter Grundgehäuse miteinander verbunden, wobei die Verbindung wiederum, wie oben erläutert formschlüssig, kraftschlüssig oder stoffschlüssig hergestellt sein kann.

Denkbar ist auch, dass zusätzlich oder alternativ benachbarte Steckermodule miteinander verbunden sind, wobei die Verbindung wiederum formschlüssig, kraftschlüssig oder stoffschlüssig erfolgen kann.

Eine Anschlussvorrichtung weist vorzugsweise mehrere Anschlusszeilen nach der vorangehend beschriebenen Art auf. Die Anschlusszeilen werden hierbei entlang einer Breitenrichtung quer zur Anreihrichtung und quer zur Einsetzrichtung aneinander angereiht.

Hierbei weisen die Anschlusszeilen, gemessen entlang der Breitenrichtung, vorzugsweise jeweils die gleiche Breite auf. Dies ermöglicht, die Anschlusszeilen in Verbindung mit baugleichen Elektronikgehäusen zu verwenden, wobei jede Anschlusszeile aus Grundgehäusen des gleichen Baukastens ausgebildet sein kann. Jede Anschlusszeile kann hierbei auf unterschiedliche Weise durch eine unterschiedliche Kombination von Grundgehäusen zusammengesetzt sein, so dass sich modulare Elektronikgeräte mit unterschiedlichen Anschlusszeilen ergeben, die in Breitenrichtung aneinander angereiht und an eine gemeinsame Trägerschiene angesetzt werden können.

Indem jedes Grundgehäuse dieselbe Breite aufweist, weisen die Anschlusszeilen vorzugsweise jeweils, betrachtet entlang der Anreihrichtung, eine konstante Breite auf. Die Breite einer Anschlusszeile variiert somit in Längsrichtung, also entlang der Anreihrichtung, nicht, sondern ist konstant.

Ebenso können die Anschlusszeilen die gleiche Höhe, gemessen entlang der Einsetzrichtung, aufweisen. Dies ist insbesondere dann vorteilhaft, wenn die Anschlusszeilen nach außen hin an den Oberseiten der Grundgehäuse eine einheitliche, plane Außenfläche, an die beispielsweise Einzelleiter oder Stecker angeschlossen werden können, zur Verfügung stellen sollen.

Die Anschlusszeilen können in die Einsetzrichtung an mehrere Elektronikgehäuse angesetzt werden. In den Elektronikgehäusen sind hierbei Elektronikbauteile in Form von Leiterplatten aufgenommen, wobei die Anschlusszeilen in einem Endmontagezustand an die Elektronikgehäuse angesetzt und mit den darin aufgenommen Elektronikbauteilen verbunden sind.

Denkbar und möglich ist in diesem Zusammenhang auch, dass mehrere Anschlusszeilen an ein Elektronikgehäuse angesetzt und mit einem oder mehreren in dem einen Elektronikgehäuse angeordneten Elektronikbauteilen verbunden sind.

Ein jedes Elektronikgehäuse weist vorzugsweise eine erste Wandung und eine der ersten Wandung gegenüberliegende, zweite Wandung auf. Die zweite Wandung ist hierbei in Breitenrichtung quer zur Einsetzrichtung und quer zur Anreihrichtung von der ersten Wandung beabstandet, so dass die erste Wandung und die zweite Wandung zwischen sich eine Einsetzöffnung ausbilden, in die die Anschlusszeile eingesetzt ist. Die dem Elektronikgehäuse zugeordnete Anschlusszeile weist hierbei an einem oder an mehreren Grundgehäusen einen Einsetzabschnitt auf, der zwischen die Wandungen des Elektronikgehäuses eingesetzt ist und in eingesetztem Zustand zwischen den Wandungen zu liegen kommt. Die Breite der Einsetzöffnung entspricht hierbei, gemessen entlang der Breiterichtung, im Wesentlichen der Breite der Anschlusszeile an den Einsetzabschnitten der Grundgehäuse, so dass die Einsetzabschnitte passend zwischen die Wandungen des Elektronikgehäuses eingesetzt sind.

Die Anschlusszeile kann hierbei auch einen Rahmen aufweisen, der mehrere aneinander gereihte Grundgehäuse zumindest abschnittsweise einfasst, wobei die Anschlusszeile mit ihrem Rahmen an das Elektronikgehäuse angesetzt werden kann.

Darunter, dass die Breite der Einsetzöffnung im Wesentlichen der Breite der Anschlusszeile an dem Einsetzabschnitt entspricht, ist vorliegend zu verstehen, dass die Breite der Anschlusszeile (gemessen an dem Einsetzabschnitt, mit dem die Anschlusszeile in die Einsetzöffnung eingesetzt ist) nicht mehr als um eine Toleranz von +/-5%, vorzugsweise +/-2% oder gar +/-1%, von der Breite der Einsetzöffnung abweicht.

Die Gesamtbreite der Anschlusszeile - gemessen an einem Kopf der Grundgehäuse, der nach außen hin aus dem Grundgehäuse heraus vorsteht - kann vorzugsweise der Gesamtbreite des Elektronikgehäuses, also der Breite der Einsetzöffnung zuzüglich der Wandungsstärke der ersten und zweiten Wandung, entsprechen. Die seitlichen Außenwandungen des Elektronikgehäuses fluchten somit mit der Anschlusszeile, so dass die Anschlusszeile und das Elektronikgehäuse nach außen hin dieselbe Breite aufweisen.

Das Elektronikgehäuse weist weiterhin vorteilhafterweise quer zur ersten Wandung und zur zweiten Wandung erstreckte weitere Wandungen auf, die die Einsetzöffnung entlang der Anreihrichtung begrenzen, wobei die Einsetzöffnung, gemessen entlang der Anreihrichtung, eine Länge aufweist, die im Wesentlichen der Länge der Anschlusszeile entspricht. Durch die Wandlungen des Elektronikgehäuses wird somit eine kastenartige Aufnahme geschaffen, in der das Elektronikbauteil in Form einer Leiterplatte aufgenommen und in die die Anschlusszeile eingesetzt werden kann. Die Länge der Anschlusszeile entspricht hierbei der Länge der Einsetzöffnung (gemessen in Anreihrichtung), mit einem Toleranzbereich von +/-5% vorzugsweise +/-2% oder gar +/-1%.

Die Anschlusszeile verschließt vorzugsweise in an das Elektronikgehäuse angesetztem Zustand die Einsetzöffnung. Die Einsetzöffnung dient somit zur Aufnahme der Anschlusszeile, wobei bei angesetzter Anschlusszeile die Einsetzöffnung nach außen hin verschlossen ist und somit keine weiteren Maßnahmen, insbesondere keine weiteren Abdeckelemente, Blenden oder dergleichen, vorgesehen werden müssen, um die Einsetzöffnung nach außen hin zu verschließen.

In angesetztem Zustand steht die Anschlusszeile vorzugsweise nach außen hin aus dem Elektronikgehäuse vor, so dass außerhalb des Elektronikgehäuses elektrische Einzelleiter oder Stecker an die Anschlusszeile angeschlossen werden können. Die einzelnen Grundgehäuse einer Anschlusszeile können hierbei beispielsweise jeweils einen Einsetzabschnitt aufweisen, der in die Einsetzöffnung eingesetzt ist und in eingesetztem Zustand zwischen den Wandungen der Einsetzöffnung zu liegen kommt. An diesen Einsetzabschnitt schließt bei jedem Grundgehäuse ein Kopf an, der nach außen hin von dem Elektronikgehäuse vorsteht und somit außerhalb des Elektronikgehäuses angeordnet ist. An diesem Kopf sind vorzugsweise Kontaktaufnahmen mit daran angeordneten Kontakten angeordnet, an die elektrische Einzelleiter oder Stecker angeschlossen werden können.

Ein Elektronikgerät weist vorzugsweise ein Elektronikgehäuse auf, in dem ein Elektronikbauteil angeordnet ist. Die Anschlusszeile ist mit dem Elektronikbauteil verbunden und an das Elektronikgehäuse angesetzt, so dass über die Anschlusszeile elektrische Einzelleiter oder Stecker an das Elektronikgerät angeschlossen werden können. Das Elektronikgerät kann mit seinem Elektronikbauteil beispielsweise als Steuereinrichtung in einem Feldbussystem zum Steuern von Anlagen dienen, wobei beispielsweise Sensorsignale von angeschlossenen Sensoren als Eingabe aufgenommen und Steuerbefehle als Ausgaben an angeschlossene Aktoren ausgegeben werden können.

Das Elektronikbauteil ist vorzugsweise durch eine Leiterplatte ausgebildet, die in dem Elektronikgehäuse aufgenommen ist. Die Leiterplatte erstreckt sich in in das Elektronikgehäuse eingestecktem Zustand vorzugsweise flächig entlang einer durch die Anreihrichtung und die Einsetzrichtung aufgespannten Ebene, wobei die Anschlusszeile mit der Leiterplatte kontaktiert und an der Leiterplatte in kontaktierender Weise gehalten ist.

Hierzu kann die Leiterplatte beispielsweise Kontaktöffnungen aufweisen, in die in Breitenrichtung quer zur Anreihrichtung und quer zur Einsetzrichtung Kontaktstifte der Anschlusszeile eingesetzt werden können. Die Kontaktstifte stehen entlang der Breitenrichtung von Querwandungen der Grundgehäuse vor und können mit den zugeordneten Kontaktöffnungen der Leiterplatte in Eingriff gebracht werden, so dass in verbundenem Zustand (beispielsweise nach zusätzlichem Verlöten der Kontaktstifte mit der Leiterplatte) die Anschlusszeile elektrisch kontaktierend an der Leiterplatte befestigt ist.

Ein Bausatz einer oder mehrere Anschlusszeilen umfasst eine Mehrzahl von Grundgehäusen, die getrennt voneinander vorliegen und zur Bildung einer oder mehrerer Anschlusszeilen aneinander angesetzt werden können. Ein solcher Bausatz kann beispielsweise ausschließlich aus Grundgehäusen, die miteinander verbunden werden können, bestehen. Denkbar ist aber auch, dass zu einem solchen Bausatz auch ein oder mehrere Elektronikgehäuse gehören, die zusammen mit den Grundgehäusen ausgeliefert werden. Ein solcher Bausatz, der beispielsweise an einen Hersteller einer Industrieanlage, z.B. einer Montageanlage oder dergleichen, ausgeliefert werden kann, ermöglicht ein modulares Zusammensetzen von Anschlusszeilen mit Grundgehäusen in unterschiedlicher Kombination, so dass aus einem einheitlichen Bausatz unterschiedliche Anschlusszeilen zur Verbindung mit unterschiedlichen Elektronikbauteilen geschaffen werden können.

Die Aufgabe wird auch gelöst durch ein Verfahren zur Herstellung einer Anschlusszeile für eine Anschlussvorrichtung nach Anspruch 22.

Zu Vorteilen und vorteilhaften Ausgestaltungen soll auf das vorangehend Ausgeführte verwiesen werden, dass analog auch auf das Verfahren Anwendung findet.

Zur Herstellung einer Anschlussvorrichtung können die Anschlusszeilen beispielsweise entlang einer Breitenrichtung quer zur Anreihrichtung und quer zur Einsetzrichtung aneinander angereiht werden.

Eine oder mehrere Anschlusszeilen oder eine Anschlussvorrichtung nach der vorangehend beschriebenen Art können vorteilhaft an einem Elektronikgehäuse verwendet werden.

Der der Erfindung zugrunde liegende Gedanke soll nachfolgend anhand der in den Figuren dargestellten Ausführungsbeispiele näher erläutert werden. Es zeigen:
- Fig. 1: eine Ansicht von unterschiedlichen, an eine gemeinsame Trägerschiene anzusetzenden Elektronikgeräten mit jeweils einem Elektronikgehäuse und einer an das Elektronikgehäuse angesetzten Anschlusszeile;
- Fig. 2: die Anordnung gemäß Fig. 1 von oben;
- Fig. 3: eine Ansicht eines Elektronikgeräts mit einem Elektronikgehäuse und einer an das Elektronikgehäuse anzusetzenden Anschlusszeile, die aus einzelnen Grundgehäusen zusammengesetzt ist;
- Fig. 4: eine Ansicht der Anordnung gemäß Fig. 3, jedoch nur mit einem Grundgehäuse der Anschlusszeile;
- Fig. 5: eine Ansicht von Grundleistenmodulen der Anschlusszeile, in einem aneinander angesetzten Zustand;
- Fig. 6: die Grundleistenmodule gemäß Fig. 5, in einem voneinander getrennten Zustand;
- Fig. 7A: die Anordnung gemäß Fig. 5, von oben;
- Fig. 7B: eine Schnittansicht entlang der Linie A-A gemäß Fig. 7A;
- Fig. 8: ein modifiziertes Ausführungsbeispiel von Grundleistenmodulen, die miteinander verbunden werden;
- Fig. 9: die Anordnung gemäß Fig. 8, von oben;
- Fig. 10: eine Ansicht von Steckermodulen, die zur Ausbildung der Anschlusszeile mit den Grundleistenmodulen gemäß Fig. 5-9 verbunden werden;
- Fig.11: eine Ansicht der Steckermodule, in einem voneinander getrennten Zustand;
- Fig. 12: die Anordnung gemäß Fig. 10, schräg von unten;
- Fig. 13A: die Anordnung gemäß Fig. 10, von oben;
- Fig. 13B: die Anordnung gemäß Fig. 10, von der Seite;
- Fig. 14: die Steckermodule gemäß Fig. 10-13 und die Grundleistenmodule gemäß Fig. 5-9 in einem aneinander angesetzten Zustand;
- Fig. 15: die Anordnung gemäß Fig. 14 von der Seite;
- Fig. 16: die Steckermodule und die Grundleistenmodule in einem voneinander getrennten Zustand;
- Fig. 17: eine Ansicht eines anderen Ausführungsbeispiels von Grundleistenmodulen;
- Fig. 18: die Grundleistenmodule gemäß Fig. 17, in einem voneinander getrennten Zustand;
- Fig. 19A: die Anordnung gemäß Fig. 17, von oben;
- Fig. 19B: eine Schnittansicht entlang der Linie A-A gemäß Fig. 19A;
- Fig. 20: die Grundleistenmodule gemäß Fig. 17, mit daran angesetzten Steckermodulen;
- Fig. 21: die Anordnung gemäß Fig. 20, bei von den Grundleistenmodulen getrennten Steckermodulen;
- Fig. 22: eine Seitenansicht eines Elektronikgehäuses;
- Fig. 23: eine Draufsicht auf das Elektronikgehäuse;
- Fig. 24: eine Draufsicht auf das Elektronikgehäuse, mit darin angeordneten Grundleistenmodulen;
- Fig. 25: eine Draufsicht auf das Elektronikgehäuse, mit an die Grundleistenmodule angesetzten Steckermodulen;
- Fig. 26: eine vergrößerte Ansicht im Ausschnitt C gemäß Fig. 24;
- Fig. 27: eine Schnittansicht entlang der Linie B-B gemäß Fig. 25;
- Fig. 28: eine Ansicht von einteilig geformten Grundgehäusen zur Ausbildung einer Anschlusszeile;
- Fig. 29: die Grundgehäuse gemäß Fig. 28, in einem voneinander getrennten Zustand;
- Fig. 30A: eine Draufsicht auf die Grundgehäuse;
- Fig. 30B: eine Seitenansicht der Grundgehäuse;
- Fig. 30C: eine stirnseitige Ansicht der Grundgehäuse; und
- Fig. 31: eine Ansicht eines Elektronikgehäuses mit einem daran anzuordnenden Grundgehäuse nach dem Ausführungsbeispiel gemäß Fig. 28-30A, 30C.

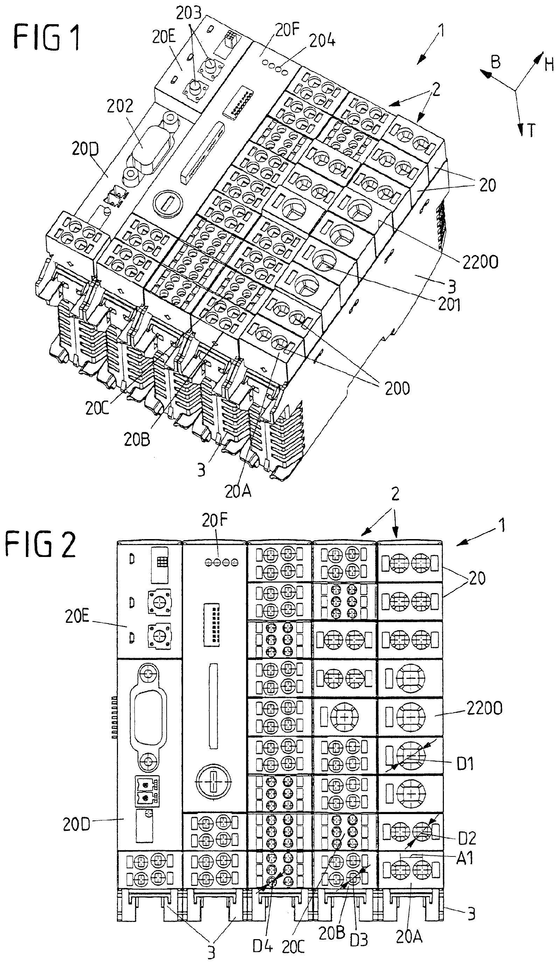

Fig. 1 und 2 zeigen eine Anschlussvorrichtung 1, die modular aus jeweils einem Elektronikgehäuse 3 und einer Anschlusszeile 2 sowie einem in dem Elektronikgehäuse 3 aufgenommenen Elektronikbauteil in Form einer Leiterplatte gebildet ist. Die Elektronikgehäuse 3 der Elektronikgeräte sind entlang einer Breitenrichtung B aneinander angereiht und können in an sich bekannter Weise an einer gemeinsame Trägerschiene angebracht werden, so dass eine kompakte Elektronikvorrichtung mit modularen, einzelnen Elektronikgeräten geschaffen wird.

Die Anschlusszeilen 2 eines jeden Elektronikgehäuses 3 erstrecken sich entlang einer Anreihrichtung H längs an den zugeordneten Elektronikgehäusen 3. Die Anschlusszeilen 2 sind dabei entlang einer Tiefenrichtung T oberhalb der Elektronikgehäuse 3 angeordnet und stehen von den Elektronikgehäusen 3 entlang der Tiefenrichtung T nach außen hin vor.

Die Anschlusszeilen 2 schaffen eine Schnittstelle zum Anschließen von elektrischen Einzelleitern oder Steckern an die in den Elektronikgehäusen 3 aufgenommenen Elektronikbauteilen. Hierzu weisen die Anschlusszeilen 2 eine Vielzahl von Kontaktaufnahmen 200 auf, in denen Kontakte 201 angeordnet sind und die beispielsweise Klemmeinrichtungen zum Anschließen von elektrischen Einzelleitern verwirklichen. Zudem sind an einzelnen Anschlusszeilen 2 Steckverbinderteile 202, Verstellelemente 203 oder Anzeigeelemente 204 vorgesehen. An ein Steckverbinderteil 202 kann ein kompatibler Stecker angeschlossen werden. Über Verstellelemente 203 kann beispielsweise eine Regelung, beispielsweise zum Verstellen eines Potentiometers, vorgenommen werden. Und über Anzeigeelemente 204 kann beispielsweise ein Systemzustand angezeigt werden.

Die Konfiguration der einzelnen Anschlusszeilen 2 ist abhängig von den in den Elektronikgehäusen 3 aufgenommenen Elektronikbauteilen. Abhängig davon, welche Funktion die in den Elektronikgehäusen 3 aufgenommenen Elektronikbauteile erfüllen, können unterschiedliche Leitungen oder Stecker unterschiedlicher externer Baueinheiten an die Anschlussteile 2 anzuschließen sein.

Beispielsweise können solche Anschlussvorrichtungen 1 Verwendung finden in Industrieanlagen, bei denen zum Beispiel Sensoren und Aktoren mit übergeordneten Steuervorrichtungen zu verbinden sind. Die Steuervorrichtungen sind durch die in den Elektronikgehäusen 3 aufgenommenen Elektronikbauteile verwirklicht und empfangen Sensorsignale von Sensoren, die über die Anschlusszeilen 2 angeschlossen sind, und geben Steuersignale an Aktoren, die ebenfalls über die Anschlusszeilen 2 angeschlossen sind, ab.

Im Sinne der vorliegenden Erfindung sind bei der Anschlussvorrichtung 1 die Anschlusszeilen 2 jeweils aus unterschiedlichen Grundgehäusen 20, 20A-20F zusammengesetzt. Die Grundgehäuse 20, 20A-20F sind hierbei zur Ausbildung einer Anschlusszeile 2 entlang einer Anreihrichtung H aneinander angesetzt und weisen beispielsweise unterschiedliche Anzahlen von Kontaktaufnahmen 200 und daran angeordneten Kontakten 201 auf. Die Grundgehäuse 20, 20A-20F können sich hierbei in der Anzahl der Kontaktaufnahmen, in der Größe der Kontaktaufnahmen, in der Formgebung der Kontaktaufnahmen, in der Anzahl der in den Kontaktaufnahmen angeordneten Kontakte, in der Größe oder Form der Kontakte, in der Anordnung der Kontakte oder dergleichen unterscheiden. Zudem kann ein Grundgehäuse 20, 20A-20F auch eine andere Funktion als das Anschließen von elektrischen Einzelleitern oder Steckern verwirklichen und beispielsweise als Bedienelement oder als Anzeigeelement dienen.

Bei dem in Fig. 1 und 2 dargestellten konkreten Ausführungsbeispiel weist das Grundgehäuse 20A beispielsweise zwei Kontaktaufnahmen 200 auf, die zum Anschließen zweier elektrischer Einzelleiter nach Art von Klemmeinrichtungen, beispielsweise Federklemmen, ausgestaltet sein können. Das Grundgehäuse 20B hingegen weist vier Kontaktaufnahmen 200 auf, die in ihrem Durchmesser kleiner sind als die zwei Kontaktaufnahmen 200 des Grundgehäuses 20A. Das Grundgehäuse 20C wiederum weist sechs Kontaktaufnahmen 200 auf, die in ihrem Durchmesser kleiner sind als die Kontaktaufnahmen 200 des Grundgehäuses 20B und des Grundgehäuses 20A. Ein anderes Grundgehäuse 20D weist ein Steckverbinderteil 202 nach Art eines D-Sub-Steckers auf. Ein wiederum anderes Grundgehäuse 20E verwirklicht ein Bedienelement mit zwei daran angeordneten Verstellelementen 203 nach Art von Drehreglern. Und ein Grundgehäuse 20F verwirklicht ein Anzeigeelement mit einer daran angeordneten Anzeigeeinrichtung in Form von Leuchtdioden.

Wie aus Fig. 1 und 2 ersichtlich, können unterschiedliche Kontaktaufnahmen 200 und Kontakte 201 von unterschiedlichen Grundgehäusen 20, 20A-20C unterschiedlich ausgebildet sein. So können die Kontaktaufnahmen 200 unterschiedliche Durchmesser D1-D4 aufweisen, oder Kontakte 201 unterschiedlicher Grundgehäuse 20, 20A-20C können unterschiedliche Abstände A1 zueinander haben. Kontaktaufnahmen 200 mit einem großen Durchmesser können hierbei zur Aufnahme von Einzelleitern mit einem großen Durchmesser und entsprechend einer großen Stromtragfähigkeit ausgebildet sein, während kleine Kontaktaufnahmen 200 zur Aufnahme von Leitern mit kleinem Durchmesser und entsprechend kleiner Stromtragfähigkeit dienen.

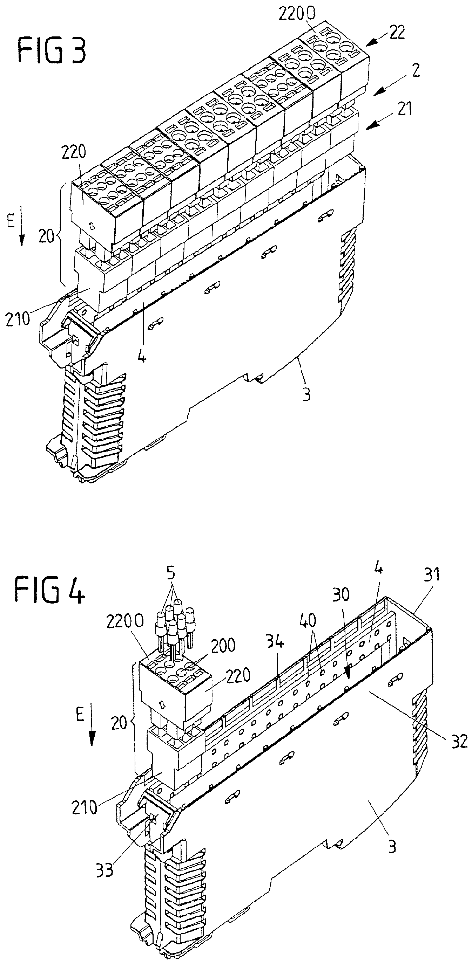

Fig. 3 und 4 zeigen ein Elektronikgehäuse 3 mit einem daran angeordneten Elektronikbauteil 4 in Form einer Leiterplatte, die Kontaktöffnungen 40 zum Anschließen von Grundgehäusen 20 der zugeordneten Anschlusszeile 2 aufweist. Die Grundgehäuse 20 sind in diesem Fall jeweils zweiteilig aus zwei Gehäuseelementen gebildet, nämlich einem Grundleistenmodul 210 und einem daran anzusetzenden Steckermodul 220. Die Steckermodule 220 verwirklichen hierbei an einer Oberseite 220O Kontaktaufnahmen 200 zum Anschließen von elektrischen Einzelleitern 5, während über die Grundleistenmodule 210 die elektrische Kontaktierung mit dem Elektronikbauteil 4 hergestellt wird.

Zur Montage wird zunächst eine Grundleiste 21 aus einer Kombination von Grundleistenmodulen 210 zusammengesetzt und über die Kontaktöffnungen 40 an das Elektronikbauteil 4 in Form der Leiterplatte angeschlossen. Die Grundleiste 21 kann sodann zusammen mit dem Elektronikbauteil 4 in einer Einsetzrichtung E, entsprechend der Tiefenrichtung T, in eine Einsetzöffnung 30 des Elektronikgehäuses 3 eingesetzt werden, so dass das Elektronikbauteil 4 und die aus den Grundleistenmodulen 210 gebildete Grundleiste 21 im Inneren des Elektronikgehäuses 3 zu liegen kommt. An die einzelnen Grundleistenmodule 210 können dann zugeordnete Steckermodule 220 in die Einsetzrichtung E eingesetzt werden, so dass in eingesetztem Zustand das Elektronikgerät komplettiert ist und - bei diesem Ausführungsbeispiel - elektrische Einzelleiter 5 an die Anschlusszeile 2 angeschlossen werden können.

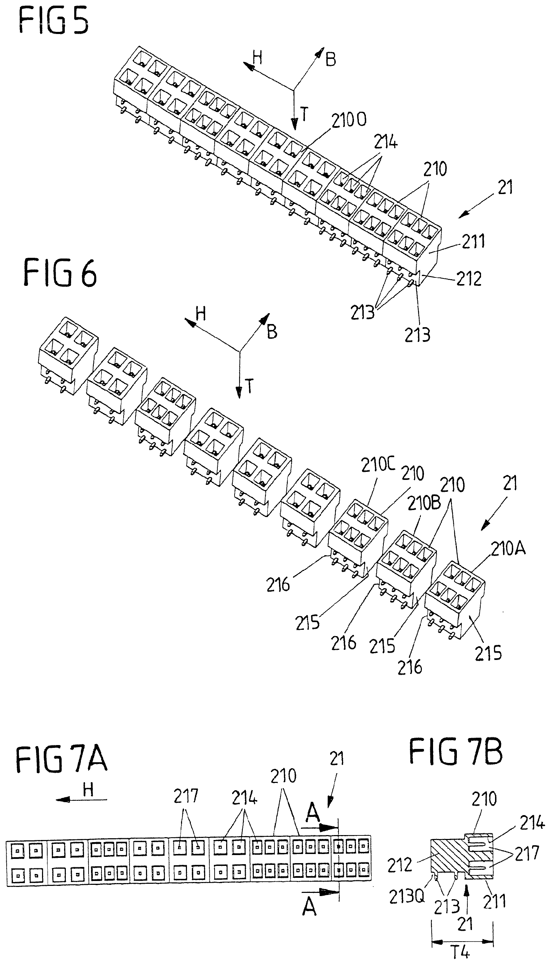

Die aus den Grundleistenmodulen 210 gebildete Grundleiste 21 ist in gesonderten Ansichten in Fig. 5 bis 7A, 7B dargestellt. Die Grundleiste 21 ist in modularer Weise aus - in diesem Beispiel - neun einzelnen Grundleisternmodulen 210 gebildet, die entlang der Anreihrichtung H aneinander angesetzt sind und mit dem Elektronikbauteil 4 verbunden werden können. Hierzu sind an jedem Grundleistenmodul 210 von einer Querwandung 213Q vorspringend Kontaktstifte 213 vorgesehen, die sich entlang der Breitenrichtung B erstrecken und mit den Kontaktöffnungen 40 des Elektronikbauteils 4 steckend in Eingriff gebracht werden können.

An einer Oberseite 210O weisen die Grundleistenmodule 210 Kontaktaufnahmen 214 mit darin angeordneten Kontakten 217 (siehe Fig. 7B) auf, die dazu ausgestaltet sind, eine elektrische Kontaktierung mit den an die Grundleistenmodule 210 anzusetzenden Steckermodulen 220 herzustellen.

Die Grundleistenmodule 210 weisen jeweils einen Kopf 211 und eine Basis 212 auf. An dem Kopf 211 sind die Kontaktaufnahmen 214 angeordnet, während die Basis 212 an der Querwandung 213Q die Kontaktstifte 213 trägt. Gemessen entlang der Breitenrichtung B weist die Basis 212 eine geringere Breite als der Kopf 211 auf.

Jedes Grundleistenmodul 210, 210A-210C weist zwei Seitenwandungen 215, 216 auf, die sich quer zur Anreihrichtung H erstrecken und das Grundleistenmodul 210, 210A-210C seitlich begrenzen. Über die Seitenwandungen 215, 216 sind benachbarte Grundleistenmodule 210, 210A-210C aneinander angesetzt, wobei die Grundleistenmodule 210, 210A-210C über ihre Seitenwandungen 215, 216 auch fest miteinander verbunden werden können.

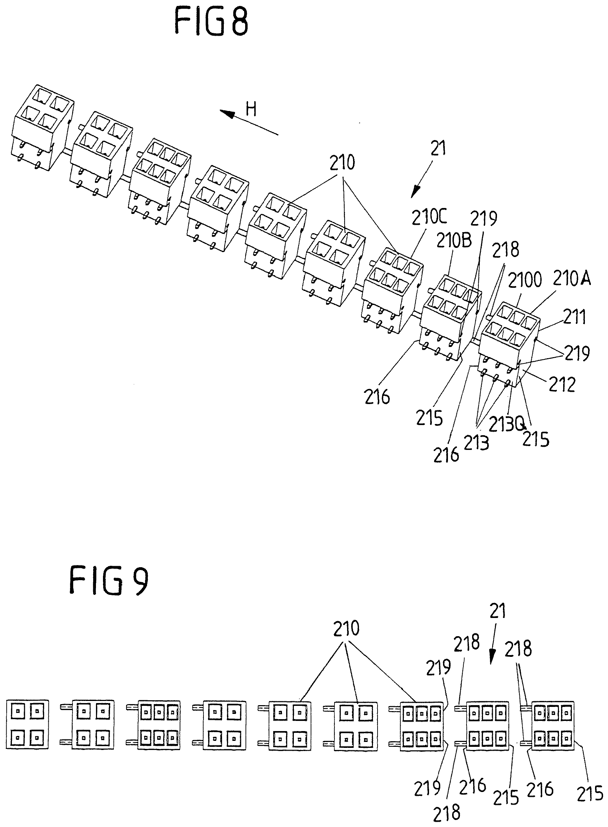

Dies zeigen in einem Ausführungsbeispiel Fig. 8 und 9. So können an einer ersten Seitenwandung 215 eines Grundleistenmoduls 210, 210A-210C Verbindungsöffnungen 219 vorgesehen sein, die mit zugeordneten Verbindungsstiften 218 an einer zweiten Seitenwandung 216 eines benachbarten Grundleistenmoduls 210, 210A-210C in Eingriff gebracht werden können. Die Grundleistenmodule 210, 210A-210C können hierbei entlang der Anreihrichtung H steckend aneinander angesetzt werden, so dass sich eine fest verbundene, einheitliche Grundleiste 21 ergibt.

Bei dem Ausführungsbeispiel gemäß Fig. 8 und 9 sind an der zweiten Seitenwandung 216 zwei Verbindungsstifte 218 angeordnet, die mit zwei zugeordneten Verbindungsöffnungen 219 an der ersten Seitenwandung 215 des benachbarten Grundleistenmoduls 210, 210A-210C in Eingriff gebracht werden können. Grundsätzlich können aber auch mehr Verbindungsstifte 218 und mehr Verbindungsöffnungen 219 vorgesehen sein.

Die Verbindung kann zudem auch auf ganz andere Weise hergestellt werden. Generell können die Grundleistenmodule 210, 210A-210C formschlüssig, kraftschlüssig oder stoffschlüssig miteinander verbunden werden, wobei ganz unterschiedliche Verbindungsarten zur Herstellung einer formschlüssigen, kraftschlüssigen oder stoffschlüssigen Verbindung denkbar und möglich sind. Eine formschlüssige Verbindung kann beispielsweise auch über eine Schwalbenschwanzführung hergestellt werden, bei der ein schwalbenschwanzförmiges Formschlusselement in eine zugeordnete Führung eingeschoben wird. Eine kraftschlüssige Verbindung kann beispielsweise über einen Presssitz, beispielsweise unter Verwendung von Verbindungsstiften 218 und Verbindungsöffnungen 219, wie sie in Fig. 8 und 9 dargestellt sind, hergestellt werden. Und eine stoffschlüssige Verbindung kann beispielsweise unter Schweißen oder auch unter Einsatz von Säure oder dergleichen zur Herstellung eines Stoffschlusses erreicht werden.

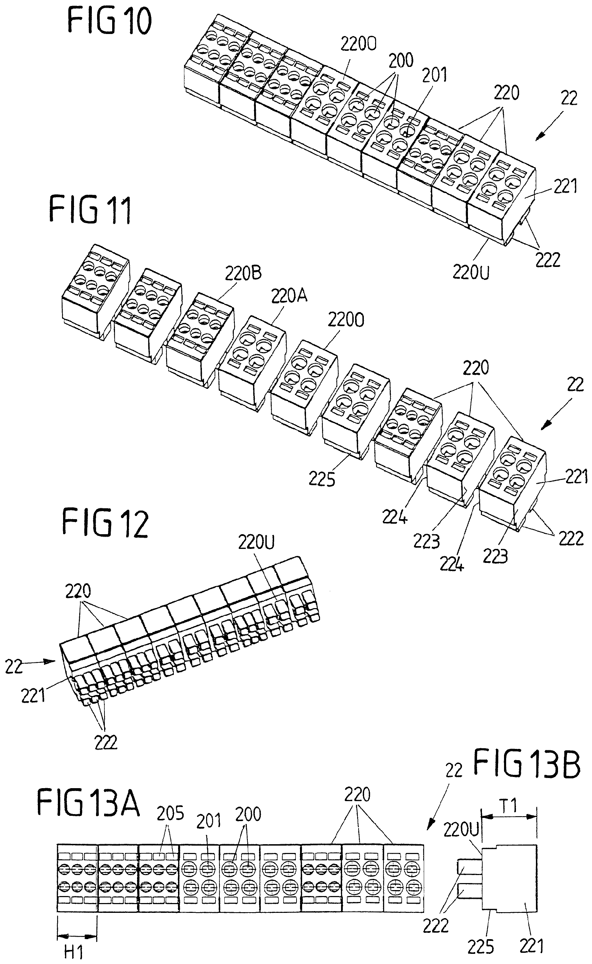

An die Grundleistenmodule 210 der Grundleiste 21 werden Steckermodule 220, die eine Steckerleiste 22 ausbilden, angesetzt. Dies ist in Fig. 10 bis 16 dargestellt. Jedes Steckermodul 220 weist hierbei an einer einem zugeordneten Grundleistenmodul 210 zugewandten Unterseite 220U Kontaktzapfen 222 auf, die steckend in Einsetzrichtung E in Eingriff mit den Kontaktaufnahmen 214 an dem Grundleistenmodul 210 gebracht werden können. Die Kontaktzapfen 222 stehen von der Unterseite 220U in Richtung des Grundleistenmoduls 210 vor und tragen jeweils einen Kontakt, der kontaktierend mit dem Kontakt 217 der zugeordneten Kontaktaufnahme 214 des Grundleistenmoduls 210 in Verbindung gebracht werden kann.

Bei dem dargestellten Ausführungsbeispiel korreliert die Anzahl der Kontaktaufnahmen 200 eines Steckermoduls 220 mit der Anzahl der Kontaktzapfen 222 des Steckermoduls 220, und die Anzahl der Kontaktzapfen 222 des Steckermoduls 220 korreliert wiederum mit der Anzahl der Kontaktaufnahmen 214 des zugeordneten Grundleistenmoduls 210 und der Anzahl der an der Querwandung 213Q angeordneten Kontaktstifte 213. Das Steckermodul 220A weist beispielsweise vier Kontaktaufnahmen 200 auf, während das benachbarte Steckermodul 220B sechs Kontaktaufnahmen 200 verwirklicht. Die zugeordneten Grundleistenmodule 210 weisen eine entsprechende Anzahl von Kontaktaufnahmen 214 und Kontaktstiften 213 auf. Über die an den Steckermodulen 220 vorgesehenen Kontaktaufnahmen 220 nach Art von Federklemmen, Schraubklemmen oder dergleichen können somit elektrische Einzelleiter an das Elektronikbauteil 4 in Form der Leiterplatte angeschlossen werden.

Jeder Kontaktaufnahme 200 eines Steckermoduls 220 ist ein Werkzeugeingriff 205 zugeordnet, über den ein elektrischer Einzelleiter mit der Kontaktaufnahme 200 verbunden oder von der Kontaktaufnahme 200 gelöst werden kann.

Zum Komplettieren der Anschlusszeile 2 werden die Steckermodule 220 an die zusammen mit dem Elektronikbauteil 4 bereits in das Elektronikgehäuse 3 eingesetzten Grundleistenmodule 210 angesetzt. Das Ansetzen der Steckermodule 220 erfolgt dabei in die Einsetzrichtung E, wobei die Steckermodule 220 beispielsweise einzeln an die zugeordneten Grundleistenmodule 210 angesetzt werden und in angesetztem Zustand mit Seitenwandungen 223, 224 (siehe Fig. 11) aneinander zu liegen kommen.

Denkbar und möglich ist dabei auch, die Steckermodule 220 zunächst zur Ausbildung einer einheitlichen Steckerleiste 22 über ihre Seitenwandungen 223, 224 miteinander zu verbinden, so dass eine einheitliche Steckerleiste 22 geschaffen wird, die an die zugeordnete Grundleiste 21 angesetzt werden kann.

Die Grundleistenmodule 210 weisen bei dem dargestellten Ausführungsbeispiel jeweils eine entlang der Anreihrichtung H gemessene einheitliche Länge H1 auf, wie dies in Fig. 7A eingezeichnet ist. Die Grundleistenmodule 210 sind somit entlang der Anreihrichtung H gleichlang.

Zudem weisen die Grundleisten bei dem dargestellten Ausführungsbeispiel auch eine einheitliche Tiefe T4 auf, eingezeichnet in Fig. 7B.

Entsprechendes gilt für die Steckermodule 220, die eine einheitliche Länge H1 entlang der Anreihrichtung H (siehe Fig. 13A) aufweisen, die der Länge H1 der Grundleistenmodule 210 entspricht. Zudem weisen die Steckermodule 220 auch eine einheitliche Tiefe T1 auf.

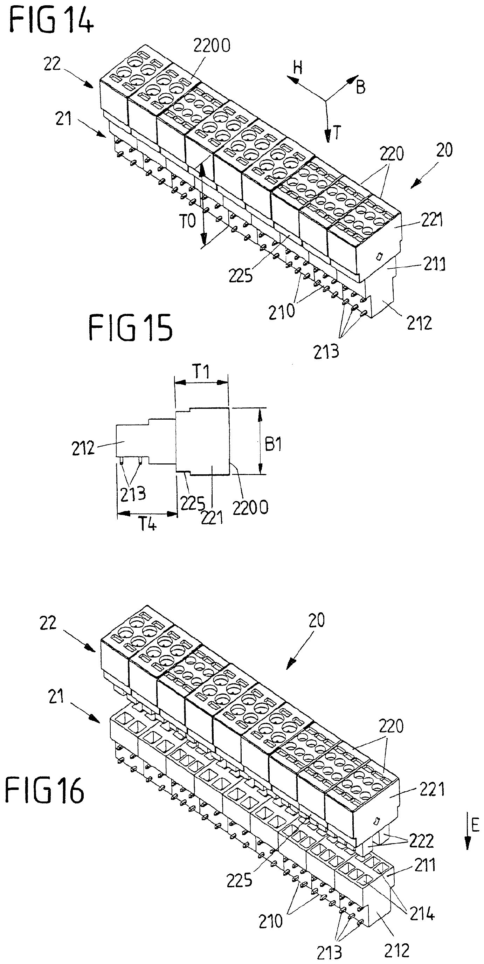

Es ergibt sich eine Anschlusszeile 2, die - wie in Fig. 14 bis 16 dargestellt - betrachtet entlang der Anreihrichtung H eine konstante Tiefe T0, zusammengesetzt aus den Tiefen T1, T4 der Steckermodule 220 und der Grundleistenmodule 210, aufweist. Die Oberseiten 220O der Steckermodule 220 bilden somit eine einheitliche, plane Fläche, über die elektrische Einzelleiter an die Anschlusszeile 2 angeschlossen werden können.

Bei dem Ausführungsbeispiel sind die Steckermodule 220 einerseits und die Grundleistenmodule 210 andererseits jeweils in ihren äußeren Abmessungen identisch ausgebildet, weisen also die gleiche Länge, Tiefe und Breite auf. Die äußere Breite der Anschlusszeile 2 wird hierbei bestimmt durch die Breite B1 an Köpfen 221 der Steckermodule 220. Dadurch, dass die Breite B1 für jedes Steckermodul 220 gleich ist, ist die Breite B1 der Anschlusszeile 2 entlang der Anreihrichtung H konstant.

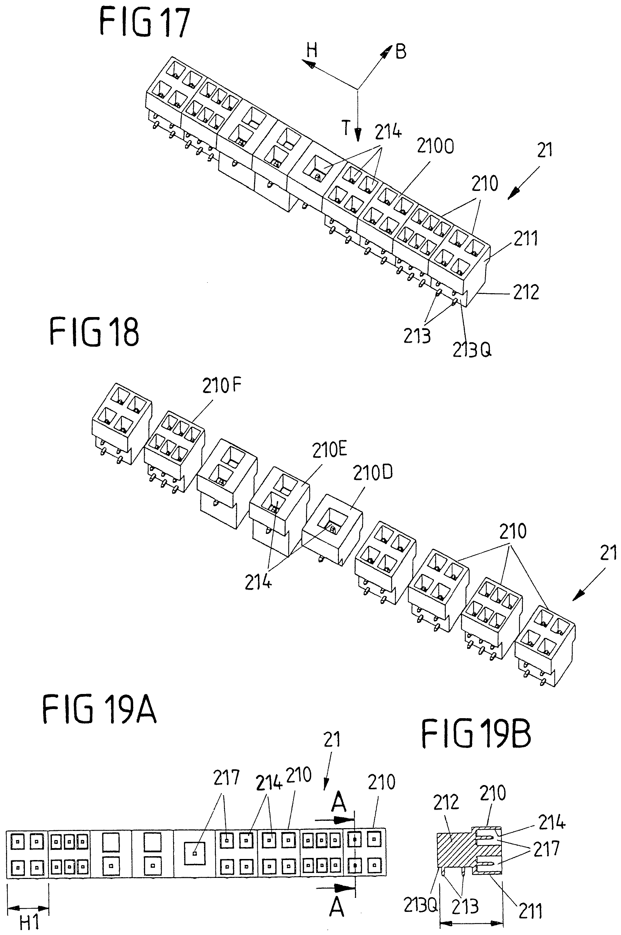

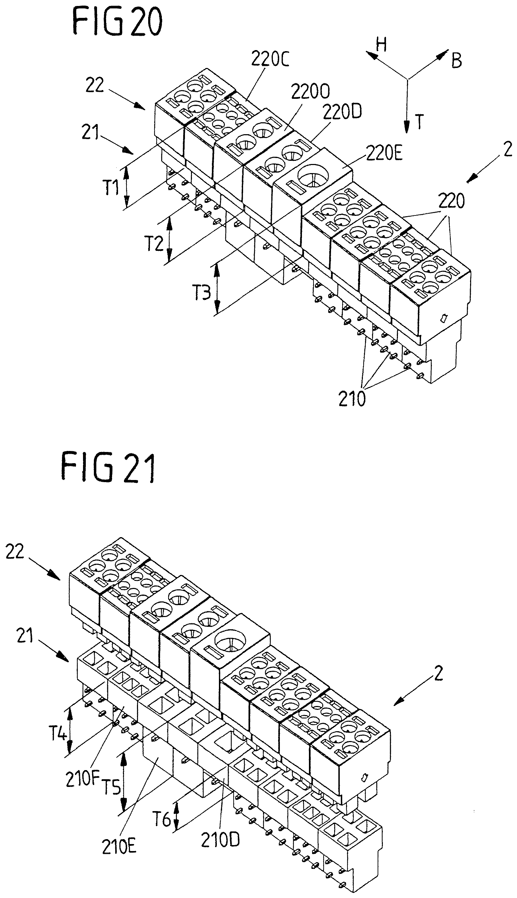

Bei den grade geschilderten Ausführungsbeispielen ist die Tiefe T0 der Anschlusszeile 2 entlang der Anreihrichtung H konstant. Im Gegensatz hierzu ist bei dem Ausführungsbeispiel gemäß Fig. 17 bis 21 die Tiefe der Anschlusszeile 2 entlang der Anreihrichtung H nicht konstant, sondern variiert entlang der Anschlusszeile 2, bedingt dadurch, dass sowohl die Steckermodule 220 der Steckerleiste 22 als auch die Grundleistenmodule 210 der Grundleiste 21 unterschiedliche Tiefen T1-T6 aufweisen. Dies führt dazu, dass die Oberseiten 220O unterschiedlicher Steckermodule 220C, 220D, 220E zueinander versetzt sind, wie sich dies aus Fig. 20 und 21 ergibt, und somit bei an das Elektronikgehäuse 3 angesetzter Anschlusszeile 2 keine ebene, plane Oberfläche nach außen hin geschaffen wird. Zudem erstrecken sich auch die Grundleistenmodule 210D, 210E, 210F unterschiedlich tief in das Elektronikgehäuse 3 hinein, bedingt dadurch, dass die Grundleistenmodule 210D, 210E, 210F unterschiedliche Tiefen T4, T5, T6 aufweisen.

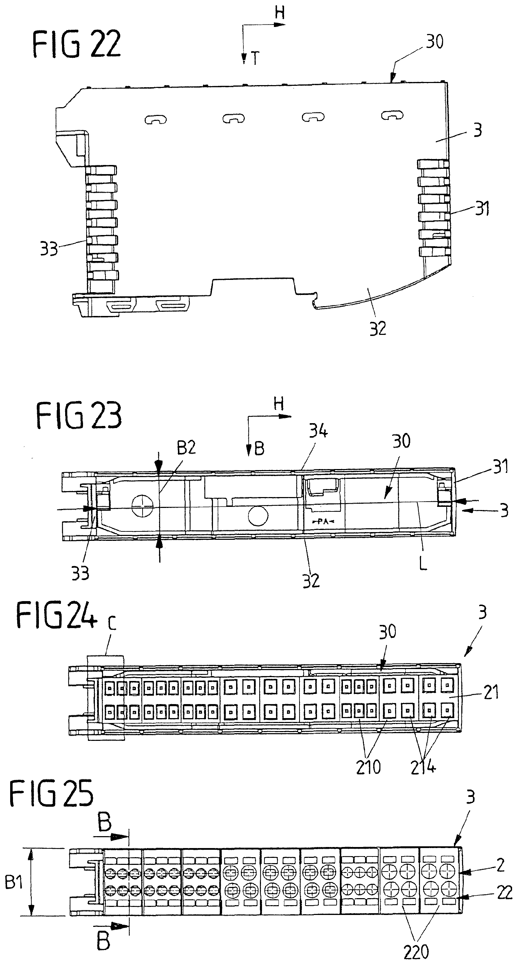

Fig. 22 bis 27 veranschaulichen die Größenverhältnisse des Elektronikgehäuses 3 und der an das Elektronikgehäuse 3 angesetzten Anschlusszeilen 2. Wie aus Fig. 22 und 23 ersichtlich, weist das Elektronikgehäuse 3 eine im Wesentlichen kastenartige Gestalt auf mit seitlichen Wandungen 32, 34 und stirnseitigen Wandungen 31, 33, die zwischen sich eine Aufnahmeöffnung 30 zum Aufnehmen des Elektronikbauteils 4 und zum Einstecken der Anschlusszeile 2 ausbilden. Die seitlichen Wandungen 32, 34 sind hierbei entlang der Breitenrichtung B zueinander beabstandet, während sich die stirnseitigen Wandungen 31, 33 entlang der Anreihrichtung H gegenüberliegen. In die Einsetzöffnung 30 können das Elektronikbauteil 4 und die Anschlusszeile 2 in die Einsetzrichtung E eingesetzt werden.

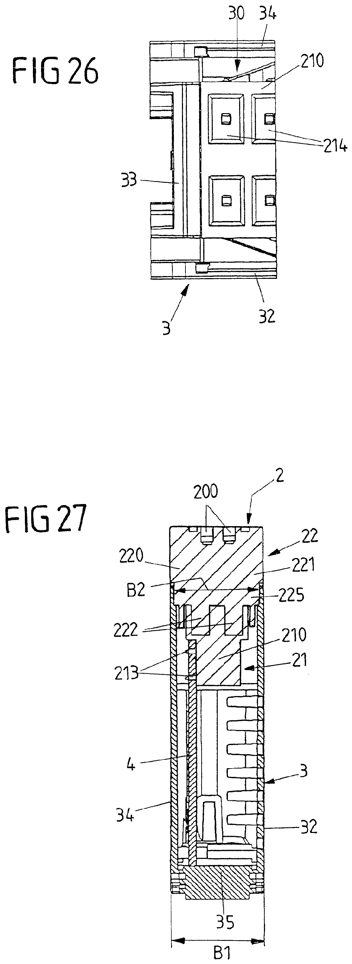

Die durch die Grundleistenmodule 210 gebildete Grundleiste 21 kommt hierbei in eingesetztem Zustand im Inneren des Elektronikgehäuses 3 zu liegen, wobei die zwischen den stirnseitigen Wandungen 31, 33 gemessene Länge L der Einsetzöffnung 30 im Wesentlichen der Länge der Grundleiste 21 entspricht, wie sich dies aus Fig. 24 ergibt. In eingesetztem Zustand liegt das endseitige Grundleistenmodul 210, wie in Fig. 26 dargestellt, im Wesentlichen bündig an der begrenzenden stirnseitigen Wandung 33 an.

Bei angesetzter, aus den Steckermodulen 220 gebildeter Steckerleiste 22 ist die Einsetzöffnung 30 verschlossen, wobei an den Köpfen 221 der Steckermodule 220 gebildete Einsetzabschnitte 225 bündig zwischen die seitlichen Wandungen 32, 34 des Elektronikgehäuses 3 eingesetzt sind. Die Breite B2 der Einsetzöffnung 30 in Breitenrichtung B entspricht hierbei im Wesentlichen der Breite der Einsetzabschnitte 225 der Steckermodule 220, wie dies aus Fig. 27 ersichtlich ist.

Gleichzeitig entspricht die äußere Breite B1 der Steckerleiste 2 der äußeren Breite des Elektronikgehäuses 3, wie dies ebenfalls aus Fig. 27 ersichtlich ist. Die äußere Breite des Elektronikgehäuses 3, die sich durch die innere Breite B2 der Eintrittsöffnung 30 zuzüglich der Wandungsstärke der seitlichen Wandungen 32, 34 bemisst, entspricht der Breite B1 an den Köpfen 221 der Steckermodule 220.

In komplettiertem Zustand ragen die Steckermodule 220 der Steckerleiste 22 mit ihren Köpfen 221 aus dem Elektronikgehäuse 3 heraus, so dass über die Köpfe 221 elektrische Einzelleiter an die Anschlusszeile 2 angeschlossen werden können. Bei an die Grundleiste 21 angesetzter Steckerleiste 22 ist zudem die Einsetzöffnung 30 nach außen hin verschlossen, so dass das Elektronikgehäuse 3 geschlossen ist. Dies wird über die Anschlusszeile 2 erreicht, ohne dass zusätzliche Abdeckelemente zum Verschließen des Elektronikgehäuses 3 erforderlich sind.

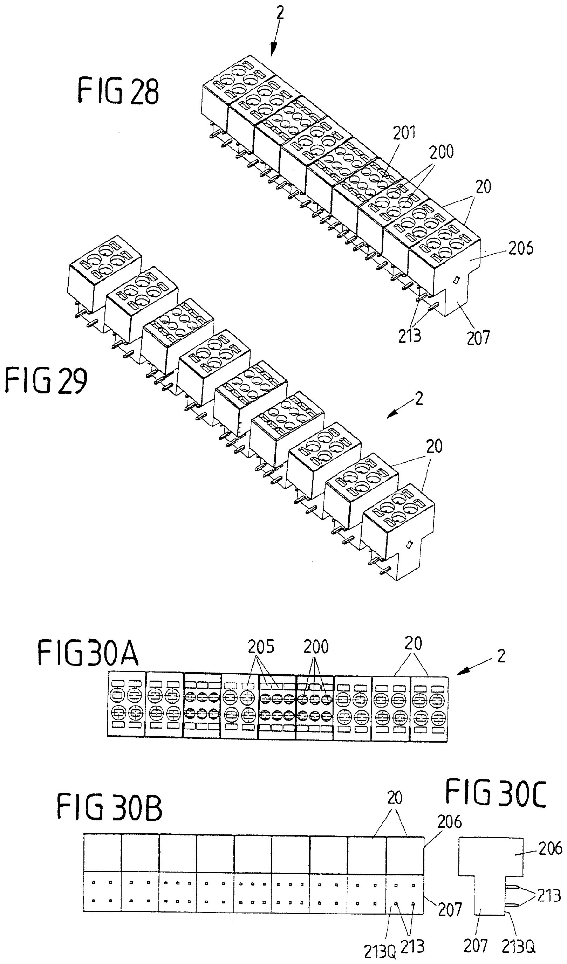

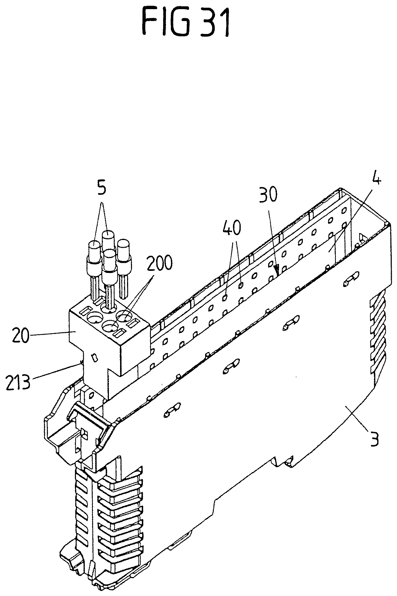

Fig. 28 bis 31 zeigen ein anderes Ausführungsbeispiel einer Anschlusszeile 2, die aus Grundgehäusen 20 mit lediglich einem Gehäuseteil hergestellt ist. Die Grundgehäuse 20 verwirklichen hierbei sogenannte Printklemmen, bei denen an einem Kopf 206 Kontaktaufnahmen 200 mit darin angeordneten Kontakten 201 und an einer Basis 207 Kontaktstifte 213 zur Verbindung mit dem Elektronikbauteil 4 angeordnet sind. Anstelle der zweiteiligen Ausgestaltung mit separaten Grundleistenmodulen und Steckermodulen wird somit ein einteiliges Grundgehäuse 20 verwendet, das an das zugeordnete Elektronikbauteil 4 angeschlossen werden kann, wie dies in Fig. 31 dargestellt ist.

Ansonsten ist die durch die Grundgehäuse 20 gebildete Anschlusszeile 2 im Wesentlichen funktionsgleich dem vorangehend Beschriebenen und kann insbesondere an eine Einsetzöffnung 30 eines Grundgehäuses 3 angesetzt werden, um in angesetztem Zustand die Einsetzöffnung 30 im Wesentlichen zu verschließen.

Der der Erfindung zugrunde liegende Gedanke ist nicht auf die vorangehend geschilderten Ausführungsbeispiele beschränkt, sondern lässt sich auch in ganz anderer Weise bei anderen Ausführungsformen verwirklichen.

Insbesondere können Grundgehäuse der hier beschriebenen Art ganz unterschiedliche Elemente eines Elektronikgeräts verwirklichen, beispielsweise Anschlussklemmen, Anzeigeelemente oder Bedienelemente. Insofern muss ein Grundgehäuse nicht notwendiger Weise Kontaktaufnahmen oder Steckverbinderteile zum Anschließen von elektrischen Einzelleitern oder Steckern aufweisen.

Zudem sind die Grundgehäuse in ihrer Länge entlang der Anreihrichtung nicht notwendigerweise gleich, sondern können beispielsweise auch eine Länge entsprechend einem ganzzahligen Vielfachen eines vorbestimmten Teilungsmaßes aufweisen. So kann ein erstes Grundgehäuse beispielsweise eine erste Länge und ein zweites Grundgehäuse beispielsweise eine zweite Länge, die dem Doppelten oder Dreifachen der ersten Länge entspricht, aufweisen, wobei andere Grundgehäuse wiederum andere Längen aufweisen können.

### Bezugszeichenliste

- 1: Anschlussvorrichtung
- 2: Anschlusszeile
- 20, 20A-20F: Grundgehäuse
- 200: Kontaktaufnahme
- 201: Kontakt
- 202: Steckverbinderteil
- 203: Verstellelement
- 204: Anzeigeelement
- 205: Werkzeugeingriff
- 206: Kopf
- 207: Basis
- 21: Grundleiste
- 210, 210A-210F: Grundleistenmodul
- 210O: Oberseite
- 211: Kopf
- 212: Basis
- 213: Kontaktstifte
- 213Q: Querseite
- 214: Kontaktaufnahmen
- 215, 216: Seitenwand
- 217: Kontakte
- 218: Verbindungselemente
- 219: Verbindungsöffnungen
- 22: Steckerleiste
- 220, 220A-220E: Steckermodul
- 220O: Oberseite
- 220U: Unterseite
- 221: Kopf
- 222: Kontaktzapfen
- 223, 224: Seitenwand
- 225: Einsetzabschnitt
- 3: Elektronikgehäuse
- 30: Einsetzöffnung
- 31-34: Seitenwandung
- 35: Bodenwandung
- 4: Elektronikbauteil (Leiterplatte)
- 40: Kontaktöffnungen
- 5: Einzelleiter
- A1: Abstand
- B: Breitenrichtung
- B1: Breite
- B2: Öffnungsbreite
- D1-D4: Abmessung
- E: Einsetzrichtung
- H: Anreihrichtung
- H1: Länge
- L: Länge
- T: Tiefenrichtung
- T0-T6: Tiefe

## Patentansprüche

1. Anschlusszeile für eine Anschlussvorrichtung, die in eine Einsetzrichtung an ein Elektronikgehäuse ansetzbar und mit einem in dem Elektronikgehäuse aufzunehmenden Elektronikbauteil verbindbar ist, wobei an die Anschlusszeile eine vorbestimmte Anzahl von elektrischen Einzelleitern oder Steckern zum Herstellen einer Verbindung der elektrischen Einzelleiter oder Stecker mit dem Elektronikbauteil anschließbar ist,
wobei die mindestens eine Anschlusszeile (2) zusammengesetzt ist aus einer Mehrzahl von Grundgehäusen (20, 20A-20F), von denen sich zumindest zwei Grundgehäuse (20,20A-20F) unterscheiden, wobei die Grundgehäuse (20, 20A-20F) in einem Vormontagezustand getrennt voneinander vorliegen und zur Bildung der Anschlusszeile (2) entlang einer Anreihrichtung (H) aneinander ansetzbar sind,
wobei die Grundgehäuse (20, 20A-20F) jeweils eine in Anreihrichtung (H) gemessene Länge (H1) aufweisen, die einem vorbestimmten Teilungsmaß (H1) oder einem ganzzahligen Vielfachen des vorbestimmten Teilungsmaßes (H1) entspricht,
**dadurch gekennzeichnet, dass**
die Grundgehäuse (20, 20A-20F) jeweils eine quer zur Anreihrichtung (H) erstreckte, erste Seitenwandung (215) und eine zur ersten Seitenwandung (215) parallele, zweite Seitenwandung (216) aufweisen, wobei benachbarte Grundgehäuse (20, 20A-20F) derart aneinander angesetzt sind, dass die erste Seitenwandung (215) eines Grundgehäuses (20-20A-20F) an der zweiten Seitenwandung (216) eines benachbarten Grundgehäuses (20-20A-20F) anliegt
und
benachbarte Grundgehäuse (20, 02A-20F) in einem Montagezustand, in dem die Grundgehäuse (20, 20A-20F) aneinander angesetzt sind, über die aneinander anliegenden Seitenwandungen (215, 216) formschlüssig, kraftschlüssig oder stoffschlüssig miteinander verbunden sind.

2. Anschlusszeile nach Anspruch 1, **dadurch gekennzeichnet, dass** die Grundgehäuse (20, 20A-20F) aus einem elektrisch isolierenden Material gefertigt sind.

3. Anschlusszeile nach einem der Ansprüche 1 oder 2, **dadurch gekennzeichnet, dass** an zumindest einem Grundgehäuse (20, 20A-20F) mindestens eine Kontaktaufnahme (200) zur Aufnahme eines elektrischen Kontakts (201) angeordnet ist.

4. Anschlusszeile nach einem der vorangehenden Ansprüche, **dadurch gekennzeichnet, dass** an zumindest zwei Grundgehäusen (20, 20A-20F) jeweils eine oder mehrere Kontaktaufnahmen (200) zur Aufnahme von einem oder mehreren elektrischen Kontakten (201) angeordnet sind, wobei sich die zumindest zwei Grundgehäuse (20, 20A-20F)
- durch die Anzahl der Kontaktaufnahmen (200) und/oder
- durch die geometrische Form und/oder eine Abmessung (D1-D4) der Kontaktaufnahmen (200)
und/oder bei in die Kontaktaufnahmen (200) angeordneten elektrischen Kontakten (201)
- durch die Anzahl der in die Kontaktaufnahmen (200) eingesetzten Kontakte (201) und/oder
- durch einen Abstand zwischen zwei Kontakten (201) benachbarter Kontaktaufnahmen (200) und/oder
- durch die Anordnung der Kontakte (201) in den Kontaktaufnahmen (200) und/oder
- durch eine Abmessung der Kontakte (201) und/oder
- durch die geometrische Form der Kontakte (201)
unterscheiden.

5. Anschlusszeile nach einem der vorangehenden Ansprüche, **dadurch gekennzeichnet, dass** zumindest ein Grundgehäuse (20, 20A-20F) ein Blendenelement, ein Bedienelement mit einem daran angeordneten verstellbaren Verstellelement (203) oder ein Anzeigeelement mit einer daran angeordneten Anzeigeeinrichtung (204) ausbildet.

6. Anschlusszeile nach einem der vorangehenden Ansprüche, **dadurch gekennzeichnet, dass** die Grundgehäuse (20, 20A-20F) dieselbe Breite (B1), gemessen entlang einer Breitenrichtung (B) quer zur Anreihrichtung (H) und quer zur Einsetzrichtung (E), aufweisen.

7. Anschlusszeile nach einem der vorangehenden Ansprüche, **dadurch gekennzeichnet, dass** die Grundgehäuse (20, 20A-20F) in einem Montagezustand, in dem die Grundgehäuse (20, 20A-20F) aneinander angesetzt sind, eine ebene Anschlussfläche (220O) ausbilden, an die die elektrischen Einzelleiter (5) oder Stecker anschließbar sind.

8. Anschlusszeile nach einem der vorangehenden Ansprüche, **dadurch gekennzeichnet, dass** die Grundgehäuse (20, 20A-20F) gleiche Außenabmessungen aufweisen.

9. Anschlusszeile nach einem der Ansprüche 1 bis 8,
**dadurch gekennzeichnet, dass** die Grundgehäuse (20, 20A-20F) einteilig ausgebildet sind.

10. Anschlusszeile nach einem der Ansprüche 1 bis 9, **dadurch gekennzeichnet, dass** die Grundgehäuse jeweils ein Grundleistenmodul (210, 210A-210F) und ein an das Grundleistenmodul (210, 210A-210F) ansetzbares Steckermodul (220, 220A-220E) aufweisen.

11. Anschlusszeile nach Anspruch 10, **dadurch gekennzeichnet, dass** das Grundleistenmodul (210, 210A-210F) mit dem Elektronikbauteil (4) verbindbar ist und an das Steckermodul (220, 220A-220E) eine vorbestimmte Anzahl von elektrischen Einzelleitern (5) oder Steckern anschließbar ist.

12. Anschlusszeile nach Anspruch 10 oder 11, **dadurch gekennzeichnet, dass** die Grundleistenmodule (210, 210A-210F) benachbarter Grundgehäuse (20, 20A-20F) miteinander verbunden sind.

13. Anschlussvorrichtung mit mehreren Anschlusszeilen nach einem der vorangehenden Ansprüche, **dadurch gekennzeichnet, dass** die Anschlusszeilen (2) entlang einer Breitenrichtung (B) quer zur Anreihrichtung (H) und quer zur Einsetzrichtung (E) aneinander angereiht sind.

14. Anschlussvorrichtung nach Anspruch 13, **dadurch gekennzeichnet, dass** die Anschlusszeilen (2)
- die gleiche Breite (B1), gemessen entlang der Breitenrichtung (B), und/oder
- die gleiche Höhe (T0), gemessen entlang der Einsetzrichtung (E),
aufweisen.

15. Elektronikgehäuse mit einer Anschlusszeile nach einem der Ansprüche 1 bis 12 oder einer Anschlussvorrichtung nach Anspruch 15 oder 16, **dadurch gekennzeichnet, dass** die Anschlusszeile (2) oder die Anschlussvorrichtung (1) in die Einsetzrichtung (E) an das Elektronikgehäuse (3) angesetzt ist.

16. Elektronikgehäuse nach Anspruch 15, **dadurch gekennzeichnet, dass** das Elektronikgehäuse eine erste Wandung (32) und eine der ersten Wandung (32) gegenüberliegende, zweite Wandung (34) aufweist, die in Breitenrichtung (B) quer zur Einsetzrichtung (E) und quer zur Anreihrichtung (H) voneinander beabstandet sind und zwischen sich eine Einsetzöffnung (30) ausbilden, in die die Anschlusszeile (2) mit einem Einsetzabschnitt (225) eingesetzt ist.

17. Elektronikgehäuse nach Anspruch 16, **dadurch gekennzeichnet, dass** die Breite (B2) der Einsetzöffnung (30), gemessen entlang der Breitenrichtung (B), im Wesentlichen der Breite (B2) der Anschlusszeile (2) an dem Einsetzabschnitt (225) entspricht.

18. Elektronikgehäuse nach Anspruch 16 oder 17, **dadurch gekennzeichnet, dass** das Elektronikgehäuse (3) quer zur ersten Wandung (32) und zur zweiten Wandung (43) erstreckte Wandungen (31, 33) aufweist, die die Einsetzöffnung (30) entlang der Anreihrichtung (H) begrenzen, wobei die Einsetzöffnung (30), gemessen entlang der Anreihrichtung (H), eine Länge (L) aufweist, die im Wesentlichen der Länge (L) der Anschlusszeile (2) entspricht.

19. Elektronikgerät mit einem Elektronikgehäuse nach einem der Ansprüche 15 bis 18, **dadurch gekennzeichnet, dass** in dem Elektronikgehäuse (3) ein Elektronikbauteil (4) angeordnet und die Anschlusszeile (2) mit dem Elektronikbauteil (4) verbunden ist.

20. Bausatz einer oder mehrerer Anschlusszeilen nach einem der Ansprüche 1 bis 12 oder einer Anschlussvorrichtung nach Anspruch 15 oder 16, bei dem eine Mehrzahl von Grundgehäusen (20, 20A-20F) getrennt voneinander vorliegen und zur Bildung einer oder mehrerer Anschlusszeilen (2) aneinander ansetzbar sind.

21. Bausatz nach Anspruch 20, **dadurch gekennzeichnet, dass** der Bausatz mindestens ein Elektronikgehäuse (3) aufweist, an das mindestens eine Anschlusszeile (2) ansetzbar ist.

22. Verfahren zur Herstellung einer Anschlusszeile für eine Anschlussvorrichtung, die in eine Einsetzrichtung an ein Elektronikgehäuse ansetzbar und mit einem in dem Elektronikgehäuse aufzunehmenden Elektronikbauteil verbindbar ist, wobei an die Anschlusszeile eine vorbestimmte Anzahl von elektrischen Einzelleitern oder Steckern zum Herstellen einer Verbindung der elektrischen Einzelleiter oder Stecker mit dem Elektronikbauteil anschließbar ist,
**dadurch gekennzeichnet,**
**dass** die mindestens eine Anschlusszeile (2) zusammengesetzt wird aus einer Mehrzahl von Grundgehäusen (20, 20A-20F), von denen sich zumindest zwei Grundgehäuse (20,20A-20F) unterscheiden, wobei die Grundgehäuse (20, 20A-20F) in einem Vormontagezustand getrennt voneinander vorliegen und zur Bildung der Anschlusszeile (2) entlang einer Anreihrichtung (H) aneinander angesetzt werden,
wobei die Grundgehäuse (20, 20A-20F) jeweils eine in Anreihrichtung (H) gemessene Länge (H1) aufweisen, die einem vorbestimmten Teilungsmaß (H1) oder einem ganzzahligen Vielfachen des vorbestimmten Teilungsmaßes (H1) entspricht,
wobei
die Grundgehäuse (20, 20A-20F) jeweils eine quer zur Anreihrichtung (H) erstreckte, erste Seitenwandung (215) und eine zur ersten Seitenwandung (215) parallele, zweite Seitenwandung (216) aufweisen, wobei benachbarte Grundgehäuse (20, 20A-20F) derart aneinander angesetzt sind, dass die erste Seitenwandung (215) eines Grundgehäuses (20-20A-20F) an der zweiten Seitenwandung (216) eines benachbarten Grundgehäuses (20-20A-20F) anliegt
und
benachbarte Grundgehäuse (20, 02A-20F) in einem Montagezustand, in dem die Grundgehäuse (20, 20A-20F) aneinander angesetzt sind, über die aneinander anliegenden Seitenwandungen (215, 216) formschlüssig, kraftschlüssig oder stoffschlüssig miteinander verbunden sind.

23. Verfahren nach Anspruch 22 zur Herstellung einer Anschlussvorrichtung mit mehreren Anschlusszeilen, **dadurch gekennzeichnet, dass** die Anschlusszeilen (2) entlang einer Breitenrichtung (B) quer zur Anreihrichtung (H) und quer zur Einsetzrichtung (E) aneinander angereiht werden.

24. Verwendung einer oder mehrerer Anschlusszeilen nach einem der Ansprüche 1 bis 12 oder einer Anschlussvorrichtung nach Anspruch 13 oder 14 an einem Elektronikgehäuse.

## Claims

1. Terminal row for a terminal apparatus which can be attached to an electronics housing in an insertion direction and can be connected to an electronics component which is intended to be received in the electronics housing, wherein a predetermined number of electrical individual conductors or plugs can be connected to the terminal row in order to establish a connection between the electrical individual conductors or plugs and the electronics component,
wherein the at least one terminal row (2) is composed of a plurality of main housings (20, 20A-20F), at least two main housings (20, 20A-20F) of which differ, wherein the main housings (20, 20A-20F) are present in a manner separated from one another in a preassembly state and can be attached to one another along a lining-up direction (H) for forming the terminal row (2),
wherein the main housings (20, 20A-20F) each have a length (H1) which is measured in the lining-up direction (H) and corresponds to a predetermined pitch dimension (H1) or to an integer multiple of the predetermined pitch dimension (H1),
**characterized in that** the main housings (20, 20A-20F) each have a first side wall (215) which extends transversely to the lining-up direction (H) and a second side wall (216) which is parallel to the first side wall (215), wherein adjacent main housings (20, 20A-20F) are attached to one another in such a way that the first side wall (215) of a main housing (20-20A-20F) bears against the second side wall (216) of an adjacent main housing (20-20A-20F), and
adjacent main housings (20, 02A-20F) are connected to one another in an interlocking, force-fitting or cohesive manner in an assembly state, in which the main housings (20, 20A-20F) are attached to one another, via the side walls (215, 216) which bear against one another.

2. Terminal row according to Claim 1, **characterized in that** the main housings (20, 20A-20F) are manufactured from an electrically insulating material.

3. Terminal row according to either of Claims 1 and 2, **characterized in that** at least one contact receptacle (20) for receiving an electrical contact (201) is arranged on at least one main housing (20, 20A-20F).

4. Terminal row according to one of the preceding claims, **characterized in that** one or more contact receptacles (200) for receiving one or more electrical contacts (201) are arranged on each of at least two main housings (20, 20A-20F), wherein the at least two main housings (20, 20A-20F) differ
- by way of the number of contact receptacles (200) and/or
- by way of the geometric shape and/or a dimension (D1-D4) of the contact receptacles (200)
and/or, in the case of electrical contacts (201) which are arranged in the contact receptacles (200),
- by way of the number of contacts (201) which are inserted into the contact receptacles (200) and/or
- by way of a distance between two contacts (201) of adjacent contact receptacles (200) and/or
- by way of the arrangement of the contacts (201) in the contact receptacles (200) and/or
- by way of a dimension of the contacts (201) and/or
- by way of the geometric shape of the contacts (201).

5. Terminal row according to one of the preceding claims, **characterized in that** at least one main housing (20, 20A-20F) forms a screen element, an operator control element with an adjustable adjusting element (203) arranged on the said operator control element, or an indicator element with an indicator device (204) arranged on the said indicator element.

6. Terminal row according to one of the preceding claims, **characterized in that** the main housings (20, 20A-20F) have the same width (B1), measured along a width direction (B) transversely to the lining-up direction (H) and transversely to the insertion direction (E).

7. Terminal row according to one of the preceding claims, **characterized in that** the main housings (20, 20A-20F) form a planar connection area (220O), to which the electrical individual conductors (5) or plugs can be connected, in an assembly state in which the main housings (20, 20A-20F) are attached to one another.

8. Terminal row according to one of the preceding claims, **characterized in that** the main housings (20, 20A-20F) have the same outside dimensions.

9. Terminal row according to one of Claims 1 to 8, **characterized in that** the main housings (20, 20A-20F) are formed in one piece.

10. Terminal row according to one of Claims 1 to 9, **characterized in that** the main housings each have a main strip module (210, 210A-210F) and a plug module (220, 220A-220E) which can be attached to the main strip module (210, 210A-210F).

11. Terminal row according to Claim 10, **characterized in that** the main strip module (210, 210A-210F) can be connected to the electronics component (4) and a predetermined number of electrical individual conductors (5) or plugs can be connected to the plug module (220, 220A-220E).

12. Terminal row according to Claim 10 or 11, **characterized in that** the main strip modules (210, 210A-210F) of adjacent main housings (20, 20A-20F) are connected to one another.

13. Terminal apparatus comprising a plurality of terminal rows according to one of the preceding claims, **characterized in that** the terminal rows (2) are lined up with one another along a width direction (B) transversely to the lining-up direction (H) and transversely to the insertion direction (E).

14. Terminal apparatus according to Claim 13, **characterized in that** the terminal rows (2) have
- the same width (B1), measured along the width direction (B) and/or
- the same height (T0), measured along the insertion direction (E).

15. Electronics housing having a terminal row according to one of Claims 1 to 12 or a terminal apparatus according to Claim 15 or 16, **characterized in that** the terminal row (2) or the terminal apparatus (1) is attached to the electronics housing (3) in the insertion direction (E).

16. Electronics housing according to Claim 15, **characterized in that** the electronics housing has a first wall (32) and a second wall (34) which is situated opposite the first wall (32), which walls are spaced apart from one another in the width direction (B) transversely to the insertion direction (E) and transversely to the lining-up direction (H) and form an insertion opening (30) between them, the terminal row (2) being inserted into the said insertion opening by way of an insertion section (225).

17. Electronics housing according to Claim 16, **characterized in that** the width (B2) of the insertion opening (30), measured along the width direction (B), corresponds substantially to the width (B2) of the terminal row (2) at the insertion section (225).

18. Electronics housing according to Claim 16 or 17, **characterized in that** the electronics housing (3) has walls (31, 33) which extend transversely to the first wall (32) and to the second wall (43), which walls delimit the insertion opening (30) along the lining-up direction (H), wherein the insertion opening (30), measured along the lining-up direction (H), has a length (L) which corresponds substantially to the length (L) of the terminal row (2).

19. Electronics device having an electronics housing according to one of Claims 15 to 18, **characterized in that** an electronics component (4) is arranged in the electronics housing (3) and the terminal row (2) is connected to the electronics component (4).

20. Construction kit of one or more terminal rows according to one of Claims 1 to 12 or of a terminal apparatus according to Claim 15 or 16, in which a plurality of main housings (20, 20A-20F) are present in a manner separated from one another and can be attached to one another for forming one or more terminal rows (2).

21. Construction kit according to Claim 20, **characterized in that** the construction kit has at least one electronics housing (3) to which at least one terminal row (2) can be attached.

22. Method for producing a terminal row for a terminal apparatus which can be attached to an electronics housing in an insertion direction and can be connected to an electronics component which is intended to be received in the electronics housing, wherein a predetermined number of electrical individual conductors or plugs can be connected to the terminal row in order to establish a connection between the electrical individual conductors or plugs and the electronics component,
**characterized in that**
the at least one terminal row (2) is composed of a plurality of main housings (20, 20A-20F), at least two main housings (20, 20A-20F) of which differ, wherein the main housings (20, 20A-20F) are present in a manner separated from one another in a preassembly state and are attached to one another along a lining-up direction (H) for forming the terminal row (2),
wherein the main housings (20, 20A-20F) each have a length (H1) which is measured in the lining-up direction (H) and corresponds to a predetermined pitch dimension (H1) or to an integer multiple of the predetermined pitch dimension (H1),
wherein
the main housings (20, 20A-20F) each have a first side wall (215) which extends transversely to the lining-up direction (H) and a second side wall (216) which is parallel to the first side wall (215), wherein adjacent main housings (20, 20A-20F) are attached to one another in such a way that the first side wall (215) of a main housing (20-20A-20F) bears against the second side wall (216) of an adjacent main housing (20-20A-20F), and adjacent main housings (20, 02A-20F) are connected to one another in an interlocking, force-fitting or cohesive manner in an assembly state, in which the main housings (20, 20A-20F) are attached to one another, via the side walls (215, 216) which bear against one another.

23. Method according to Claim 22 for producing a terminal apparatus having a plurality of terminal rows, **characterized in that** the terminal rows (2) are lined up with one another along a width direction (B) transversely to the lining-up direction (H) and transversely to the insertion direction (E).

24. Use of one or more terminal rows according to one of Claims 1 to 12 or a terminal apparatus according to Claim 13 or 14 on an electronics housing.

## Revendications

1. Ligne de raccordement pour un dispositif de raccordement qui peut être ajouté à un boîtier électronique dans une direction d'insertion et peut être relié à un composant électronique à loger dans le boîtier électronique, dans laquelle un nombre prédéterminé de connecteurs ou conducteurs individuels électriques peut être raccordé à la ligne de raccordement pour établir une liaison des connecteurs ou conducteurs individuels électriques avec le composant électronique,
ladite au moins une ligne de raccordement (2) étant assemblée à partir d'une pluralité de boîtiers de base (20, 20A-20F) dont au moins deux boîtiers de base (20, 20A-20F) sont différents, les boîtiers de base (20, 20A-20F) étant séparés les uns des autres dans un état de prémontage et pouvant être ajoutés les uns aux autres pour former la ligne de raccordement (2) le long d'une direction de juxtaposition (H),
les boîtiers de base (20, 20A-20F) présentant respectivement une longueur (H1), mesurée dans la direction de juxtaposition (H), qui correspond à un pas prédéterminé (H1) ou à un multiple entier du pas prédéterminé (H1),
**caractérisée en ce que** les boîtiers de base (20, 20A-20F) présentent respectivement une première paroi latérale (215) s'étendant transversalement à la direction de juxtaposition (H) et une deuxième paroi latérale (216) parallèle à la première paroi latérale (215), des boîtiers de base voisins (20, 20A-20F) étant ajoutés les uns aux autres de telle sorte que la première paroi latérale (215) d'un boîtier de base (20-20A-20F) est adjacente à la deuxième paroi latérale (216) d'un boîtier de base voisin (20-20A-20F), et
des boîtiers de base voisins (20, 02A-20F), à l'état de montage dans lequel les boîtiers de base (20, 20A-20F) sont reliés les uns aux autres par complémentarité de forme, par adhérence ou par liaison de matière par l'intermédiaire des parois latérales adjacentes (215, 216).

2. Ligne de raccordement selon la revendication 1, **caractérisée en ce que** les boîtiers de base (20, 20A-20F) sont fabriqués d'un matériau électriquement isolant.

3. Ligne de raccordement selon l'une quelconque des revendications 1 et 2, **caractérisée en ce que** sur au moins un boîtier de base (20, 20A-20F) au moins un logement de contact (200) est disposé pour loger un contact électrique (201).

4. Ligne de raccordement selon l'une quelconque des revendications précédentes, **caractérisée en ce que** sur au moins deux boîtiers de base (20, 20A-20F) respectivement un ou plusieurs logements de contact (200) sont disposés pour loger un ou plusieurs contacts électriques (201), les au moins deux boîtiers de base (20, 20A-20F) se distinguant
- par le nombre des logements de contact (200), et/ou
- par la forme géométrique et/ou une dimension (D1-D4) des logements de contact (200),
et/ou, lorsque des contacts électriques (201) sont disposés dans les logements de contact (200),
- par le nombre des contacts (201) insérés dans les logements de contact (200), et/ou
- par un espacement entre deux contacts (201) de logements de contact voisins (200), et/ou
- par la disposition des contacts (201) dans les logements de contact (200), et/ou
- par une dimension des contacts (201), et/ou
- par la forme géométrique des contacts (201).

5. Ligne de raccordement selon l'une quelconque des revendications précédentes, **caractérisée en ce qu'**au moins un boîtier de base (20, 20A-20F) réalise un élément de panneau, un élément d'actionnement doté d'un élément de réglage réglable (203) disposé sur celui-ci ou un élément d'affichage doté d'un dispositif d'affichage (204) disposé sur celui-ci.

6. Ligne de raccordement selon l'une quelconque des revendications précédentes, **caractérisée en ce que** les boîtiers de base (20, 20A-20F) présentent la même largeur (B1), mesurée le long d'une direction de largeur (B) transversalement à la direction de juxtaposition (H) et transversalement à la direction d'insertion (E).

7. Ligne de raccordement selon l'une quelconque des revendications précédentes, **caractérisée en ce que** dans un état de montage dans lequel les boîtiers de base (20, 20A-20F) ont été ajoutés les uns aux autres, les boîtiers de base (20, 20A-20F) réalisent une surface de raccordement plane (220O) permettant de raccorder les connecteurs ou conducteurs individuels électriques (5).

8. Ligne de raccordement selon l'une quelconque des revendications précédentes, **caractérisée en ce que** les boîtiers de base (20, 20A-20F) présentent les mêmes dimensions extérieures).

9. Ligne de raccordement selon l'une quelconque des revendications 1 à 8, **caractérisée en ce que** les boîtiers de base (20, 20A-20F) sont réalisés d'une seule pièce.

10. Ligne de raccordement selon l'une quelconque des revendications 1 à 9, **caractérisée en ce que** les boîtiers de base présentent respectivement un module de barrette de base (210, 210A-210F) et un module de connecteur (220, 220A-220E) pouvant être ajouté au module de barrette de base (210, 210A-210F).

11. Ligne de raccordement selon la revendication 10, **caractérisée en ce que** le module de barrette de base (210, 210A-210F) peut être relié au composant électronique (4), et un nombre prédéterminé de connecteurs ou conducteurs individuels électriques (5) peut être raccordé au module de connecteur (220, 220A-220E) .

12. Ligne de raccordement selon la revendication 10 ou 11, **caractérisée en ce que** les modules de barrette de base (210, 210A-210F) de boîtiers de base voisins (20, 20A-20F) sont reliés les uns aux autres.

13. Dispositif de raccordement comprenant plusieurs lignes de raccordement selon l'une quelconque des revendications précédentes, **caractérisé en ce que** les lignes de raccordement (2) sont juxtaposées les unes aux autres le long d'une direction de largeur (B) transversalement à la direction de juxtaposition (H) et transversalement à la direction d'insertion (E).

14. Dispositif de raccordement selon la revendication 13, **caractérisée en ce que** les lignes de raccordement (2) présentent
- la même largeur (B1), mesurée le long de la direction de largeur (B), et/ou
- la même hauteur (T0), mesurée le long de la direction d'insertion (E).

15. Boîtier électronique comprenant une ligne de raccordement selon l'une quelconque des revendications 1 à 12 ou un dispositif de raccordement selon la revendication 15 ou 16, **caractérisé en ce que** la ligne de raccordement (2) ou le dispositif de raccordement (1) est ajouté (e) au boîtier électronique (3) dans la direction d'insertion (E).

16. Boîtier électronique selon la revendication 15, **caractérisé en ce que** le boîtier électronique présente une première paroi (32) et une deuxième paroi (34) opposée à la première paroi (32) qui sont espacées l'une par rapport à l'autre dans la direction de largeur (B) transversalement à la direction d'insertion (E) et transversalement à la direction de juxtaposition (H) et réalisent entre elles une ouverture d'insertion (30) dans laquelle la ligne de raccordement (2) est insérée avec une partie d'insertion (225).

17. Boîtier électronique selon la revendication 16, **caractérisé en ce que** la largeur (B2) de l'ouverture d'insertion (30), mesurée le long de la direction de largeur (B), correspond substantiellement à la largeur (B2) de la ligne de raccordement (2) sur la partie d'insertion (225).

18. Boîtier électronique selon la revendication 16 ou 17, **caractérisé en ce que** le boîtier électronique (3) présente des parois (31, 33) s'étendant transversalement à la première paroi (32) et à la deuxième paroi qui délimitent l'ouverture d'insertion (30) le long de la direction de juxtaposition (H), l'ouverture d'insertion (30), mesurée le long de la direction de juxtaposition (H), présentant une longueur (L) qui correspond substantiellement à la longueur (L) de la ligne de raccordement (2).

19. Appareil électronique comprenant un boîtier électronique selon l'une quelconque des revendications 15 à 18, **caractérisé en ce que** qu'un composant électronique (4) est disposé dans le boîtier électronique (3) et la ligne de raccordement (2) est reliée au composant électronique (4).

20. Ensemble composé d'une ou de plusieurs lignes de raccordement selon l'une quelconque des revendications 1 à 12 ou d'un dispositif de raccordement selon la revendication 15 ou 16, dans lequel une pluralité de boîtiers de base (20, 20A-20F) sont séparés les uns des autres et peuvent être ajoutés les uns aux autres pour former une ou plusieurs lignes de raccordement (2).

21. Ensemble selon la revendication 20, **caractérisé en ce que** l'ensemble présente au moins un boîtier électronique (3) auquel au moins une ligne de raccordement (2) peut être ajoutée.

22. Procédé permettant de fabriquer une ligne de raccordement pour un dispositif de raccordement qui peut être ajouté à un boîtier électronique dans une direction d'insertion et peut être relié à un composant électronique à loger dans le boîtier électronique, dans lequel un nombre prédéterminé de connecteurs ou conducteurs individuels électriques peut être raccordé à la ligne de raccordement pour établir une liaison des connecteurs ou conducteurs individuels électriques avec le composant électronique,
**caractérisé en ce que** ladite au moins une ligne de raccordement (2) est assemblée à partir d'une pluralité de boîtiers de base (20, 20A-20F) dont au moins deux boîtiers de base (20, 20A-20F) sont différents, les boîtiers de base (20, 20A-20F), dans un état de prémontage, étant séparés les uns des autres et étant ajoutés les uns aux autres pour former la ligne de raccordement (2) le long d'une direction de juxtaposition (H),
les boîtiers de base (20, 20A-20F) présentant respectivement une longueur (H1), mesurée dans la direction de juxtaposition (H), qui correspond à un pas prédéterminé (H1) ou à un multiple entier du pas prédéterminé (H1),
dans lequel
les boîtiers de base (20, 20A-20F) présentent respectivement une première paroi latérale (215) s'étendant transversalement à la direction de juxtaposition (H) et une deuxième paroi latérale (216) parallèle à la première paroi latérale (215), les boîtiers de base voisins (20, 20A-20F) étant ajoutés les uns aux autres de telle sorte que la première paroi latérale (215) d'un boîtier de base (20-20A-20F) est adjacente à la deuxième paroi latérale (216) d'un boîtier de base voisin (20-20A-20F),
et
des boîtiers de base voisins (20, 02A-20F), dans un état de montage dans lequel les boîtiers de base (20, 20A-20F) sont ajoutés les uns aux autres, sont reliés les uns aux autres par complémentarité de forme, par adhérence ou par liaison de matière par l'intermédiaire des parois latérales (215, 216) adjacentes les unes aux autres.

23. Procédé selon la revendication 22 permettant de fabriquer un dispositif de raccordement comprenant plusieurs lignes de raccordement, **caractérisé en ce que** les lignes de raccordement (2) sont juxtaposées les unes aux autres le long d'une direction de largeur (B) transversalement à la direction de juxtaposition (H) et transversalement à la direction d'insertion (E).

24. Utilisation d'une ou de plusieurs lignes de raccordement selon l'une quelconque des revendications 1 à 12 ou d'un dispositif de raccordement selon la revendication 13 ou 14 sur un boîtier électrique.
